# EUROPEAN PATENT APPLICATION

(11) **EP 4 258 057 A1**
(43) Date of publication of application: **11.10.2023**
(21) Application number: 21899990.2
(22) Date of filing: 30.11.2021
(51) Int. Cl.: G03F 7/20, G03F 9/00

(54) **STEPPING PHOTOETCHING MACHINE AND OPERATING METHOD THEREFOR, AND PATTERN ALIGNMENT DEVICE**

(30) Priority: 04.12.2020 CN 202011412793
(71) Applicant: Parcan NanoTech Co., Ltd, Shanghai 201807 (CN)
(72) Inventor: ZHOU, Xiangqian, Shanghai 201807 (CN); YIN, Zhiyao, Shanghai 201807 (CN); RANGELOW, Ivo, Bonatar (DE); DU, Chuan, Shanghai 201807 (CN)
(74) Representative: Viering, Jentschura & Partner mbB Patent- und Rechtsanwälte
(86) International application number: PCT/CN2021/134287
(87) International publication number: WO 2022/116959

(57) **Abstract**

The present invention discloses a stepper lithography apparatus, its lithography pattern alignment device and operating method. In the present invention, several three-dimensional marks are set on the wafer as coordinate presets for positioning the wafer surface, and the three-dimensional marks are measured by the sensing technology using probe sensors to obtain coordinates of the wafer surface with sub-nanometer accuracy, the wafer stage is then moved and the new coordinates of the three-dimensional mark are measured and compared with the same three-dimensional nano-coordinates before the wafer stage is moved to obtain the error value of the wafer area position coordinates. This coordinate error is compensated by moving the relative position of the exposure beam generator and the wafer area using the closed-loop control principle to achieve accurate re-alignment of the relative coordinate positions. The present invention can be applied to deep ultraviolet and extreme ultraviolet optical lithography apparatus using masks and can also be applied in application scenarios such as sub-nanometer wafer area of electron beam/photon beam direct writing lithography or writing field horizontal and vertical alignment stitching.

## Description

### Technical field

The present invention relates to the technical field of lithography, in particular to the technical field of overlay alignment and positioning of lithographic patterns.

### Background

The development of microelectronics and optoelectronics has led to the rapid development of integrated circuit chips and integrated optical chips. These industries have become the foundation of modem computers, display screens and even the core devices and chips of the entire information industry. At present, the technology node of the modem chip industry has reached five nanometers or even smaller.

The manufacture of micro-nano devices such as chips is inseparable from lithography. Lithography technology includes ordinary optical lithography technology, deep ultraviolet/extreme ultraviolet lithography technology, electron beam lithography technology, ion beam lithography technology, etc. With the help of these key lithography technologies, fine lithographic patterns and even all-encompassing micro-nano device structures can be manufactured, such as integrated circuit chips and optoelectronic integrated chips.

Existing optical lithography systems, including deep ultraviolet optical lithography apparatus and extreme ultraviolet optical lithography apparatus, have been widely used in industrial chip manufacturing and MEMS manufacturing. As wafers become larger and larger, wafers with a diameter of 12 inches have become popular at present, and wafers with a larger size are being developed. No system can expose the entire wafer at once. The general practice is to sequentially expose a wafer area (DIE) on the wafer. After the exposure of a wafer area is completed, the wafer moves to the adjacent next wafer area through the movement of the wafer stage, and performs overlay alignment, and then is exposed. Alignment here means that the pattern to be exposed this time must be vertically aligned with the existing pattern on the wafer area (i.e., overlay alignment) before the lithography exposure this time can be performed. The alignment accuracy, that is, the overlay accuracy cannot be lower than several times of the minimum size of the circuit pattern on the wafer area. The size is currently around 5-10 nanometers. The multi-beam electron beam lithography apparatus used to make masks, such as the MBMW-101 series of Austrian high-tech company IMS, can be used for 5-nm node mask production, and its overlay alignment accuracy is below 5 nanometers. The lithography apparatus series from ASML, the TWINSCAN 3400B and 4300C of extreme ultraviolet optical lithography apparatus are used for 5 nanometer technology nodes, and their overlay accuracy is 2.5 nanometers and 1.5 nanometers, respectively. In the next step, the size of the chip structure will enter the order of 3 nanometers. Therefore, the overlay alignment positioning accuracy of the lithography apparatus facing the exposure of the wafer area must be required to be 1 nanometer or less. Faced with such a high requirement for the overlay accuracy of the wafer area, there is currently no relevant positioning technology, so innovative technologies must be invented.

The difficulty in realizing the extremely high positioning accuracy of the wafer stage also comes from a feature of the lithography process, which is also a huge disadvantage, that is, the wafer is coated with a photosensitive layer on the wafer before exposure. In lithography, the lithographic pattern will be transferred to the photosensitive layer by exposure, and then the lithographic pattern on the photosensitive layer will be transferred to the wafer by etching process. It should be noted that the photosensitive layer on the wafer is used as the upper surface of the covering wafer. This upper surface is sensitive to light, so that the electron beam or photon beam cannot be used for surface observation by irradiation (that is, exposure) before exposure, further it is not possible to penetrate the photosensitive layer to obtain a pattern of the wafer below the photosensitive layer. Therefore, the pattern to be exposed cannot be aligned with the pattern of the wafer area under the photosensitive layer, that is, the lithography apparatus can only be "operated by the blind", and the wafer stage is moved and then the beam is "operated by the blind" for exposure. This leads to inaccurate positioning of wafer exposure and large overlay errors.

### Summary

To solve the above technical problems, the present invention provides a lithography pattern alignment device being provided in a photolithography apparatus, characterized in that said device includes:
a wafer stagebeing used to carry wafer to be processed, wherein the wafer include several wafer areas and an off-site area around the wafer areas, a photosensitive layer is provided on a surface of the wafer, and the photosensitive layer is provided with three-dimensional marks, and the three-dimensional marks have a region that is not on the same level as an upper surface of the photosensitive layer;
a nano probe sensing device including a probe sensor, wherein the probe sensor is located over the photosensitive layer, and is used to move and scan in a scanning area and determine the coordinates of the three-dimensional marks in the scanning area;
an exposure beam generating device being used to provide an exposure beam required for exposure of the wafer area, and form a projected exposure area on the photosensitive layer;
a displacement actuating device being configured to adjust a relative position of the exposure beam generating device and the wafer stage according to the coordinates of the three-dimensional marks measured by the probe sensing device, so that the projected exposure area is aligned with an area of the wafer to be exposed.

Optionally, the device further includes a computer control system, wherein the computer control system is used to receive the coordinates of the three-dimensional mark measured by the nano probesensing device and compare them with reference coordinates of the three-dimensional mark to obtain the difference between the two coordinates; the computer control system is used to transmit the difference to the displacement actuating device, and control the exposure beam generating device and/or the wafer stage to move relative to each other to compensate for the difference.

Optionally, the reference coordinates are coordinates of a preset position of the three-dimensional mark when the three-dimensional mark is at the preset position, the area of the wafer to be exposed is aligned with the projected exposure area, and the reference coordinates are pre-stored in the computer control system.

Optionally,the reference coordinates are a corresponding coordinates in said scanning area, wherein the corresponding coordinates are formed by combining coordinates measured by said nano probe sensing device for said three-dimensional mark before the exposure of the wafer area with a theoretical distance that the wafer is to be moved to align a next wafer area to be exposed with the projection exposure area, theoretical distance that the wafer is to be moved in the horizontal and vertical directions is pre-stored in the computer control system.

Optionally,the three-dimensional marks on the photosensitive layer include three-dimensional marks formed on the photosensitive layer and corresponding to underlying alignment marks provided below the photosensitive layer and/or three-dimensional patterns formed by irradiation induced resist change(IIRC) formed after exposure of the surface of the photosensitive layer by the exposure beam.

Optionally,the three-dimensional mark formed on the photosensitive layer and corresponding to said underlying alignment mark is located within said wafer area or within the off-site area between adjacent wafer areas.

Optionally, the underlying alignment marks include marks made on a surface of a wafer substrate before the first exposure of the wafer and/or marks provided under the photosensitive layer in a subsequent exposure process.

Optionally,a height of the three-dimensional mark is greater than surface roughness of the photosensitive layer.

Optionally,the coordinates of the three-dimensional mark include horizontal coordinates, vertical coordinates and circumferential coordinates of the wafer.

Optionally,two or more three-dimensional marks are set on the photosensitive layer.

Optionally, the three-dimensional mark has certain graphic features, and the graphic features include at least one dot-form feature, and the dot-form feature is in a different horizontal plane from that of the upper surface of the photosensitive layer.

Optionally, the graphic features further include ridge features connected to the dot-form features, and the ridge features are not completely located in a same plane as the upper surface of the photosensitive layer.

Optionally, the three-dimensional mark is a three-dimensional structure protruding or recessing on an upper surface of the photosensitive layer.

Optionally, the three-dimensional structure is at least one of a pyramidal structure, a polygonal prism structure, and a pyramidal structure.

Optionally, each wafer area is provided with at least one three-dimensional mark, said three-dimensional mark is located in said wafer area or in an off-site area around said wafer area, reference coordinates of said three-dimensional mark are stored in advance in the computer control system.

Optionally, part of the wafer area is not provided with a corresponding three-dimensional mark and is aligned with the projected exposure area according to three-dimensional mark of the three-dimensional patterns in the previous exposed wafer area measured by the probe sensor.

Optionally,the wafer area without the corresponding three-dimensional mark is spaced apart from the wafer area with the corresponding three-dimensional mark.

Optionally,the exposure beam generating device is provided with a positioning markgenerating device, and the positioning mark generating device forms a three-dimensional positioning mark on a periphery of the wafer area while exposing the wafer area, the probe sensor calibrates a position of the wafer area to be exposed according to the three-dimensional positioning mark.

Optionally, a height of said three-dimensional mark is less than or equal to 50 microns.

Optionally,theprobe sensor is one or combinations of atomic force probe sensor with active cantilever, atomic force probe sensor with laser reflective cantilever, probe sensor head for tunnelingelectron or sensor head for nanoscale surface work function measurement.

Optionally,the probe sensor measures a structure of a surface of the wafer under the atmosphere or vacuum environment, or measures a structure of a surface of the wafer by immersing the probe sensor in the liquid under an environment of immersion.

Optionally,for liquid immersion lithography, said three-dimensional mark is a three-dimensional mark in an immersion liquid environment, or a three-dimensional mark corresponding to a region of wafer areas adjacent to a wafer areas outside the same exposure beam and without immersion environment.

Optionally, data of a structure of a surface of the three-dimensional mark measured by the probe sensor is the mathematical convolution of the structure of the surface of the three-dimensional mark and a structure of the tip of the probe sensor, a structure of the probe is measured and calibrated before measuring the three-dimensional mark using the probe sensor.

Optionally,the nano tip sensing device further comprises a micro-cantilever, said micro-cantilever is fixed at one end and said probe sensor is provided at the other end.

Optionally,the nano tip sensing device includes one or more probe sensors, and the probe sensors are fixed on one side or both sides of the exposure beam generating device through the micro cantilever.

Optionally, the exposure beam generating device includes a projection objective lens group arranged above the wafer, and the one or more probe sensors are fixed on one side or both sides of the projection objective lens group through the microcantilever.

Optionally, the wafer stage includes a moving part and a fixed part, and the probe sensor is connected to the fixed part through the micro-cantilever.

Optionally, the nano tip sensing device includes two or more probe sensors, wherein one or more probe sensors are fixed on a fixed part of the wafer stage, one or more of the probe sensors are fixed on a side of the exposure beam generating device.

Optionally,the nano tip sensing device includes two or more probe sensors, several of the probe sensors are fixed on one side or both sides of the exposure beam generating device through a connecting member, and the relative distance between the probe sensors is fixed.

Optionally,the nanotip sensing device includes three or more probe sensors, and the probe sensors are fixed on a fixed part of the wafer stage through connecting members and/or are fixed on the exposure beam generating device through connecting members, the probe sensors are located on different straight lines to determine whether the wafer is perpendicular to the exposure beam.

Optionally,each of the probe sensors tests the distance from the surface of ther wafer or the surface of the photosensitive layer corresponding to a position of the probe sensor to the exposure beam generating device, whether the wafer is perpendicular to the exposure beam is determined based on the measured distance is the same or not, and the wafer is adjusted to be perpendicular to the exposure beam through the computer control system driving said wafer stage.

Optionally, the nano tip sensing device includes a plurality of probe sensors fixed by connecting members, and the plurality of probe sensors are horizontally arranged in a row according to the distribution of the wafer area to form a horizontal array of probe sensors.

Optionally,at least one probe sensor distributed vertically is arranged at one end of the horizontal array of the probe sensors to form a L-shaped array of the probe sensors.

Optionally,both ends of the horizontal array of the probe sensors are respectively provided with probe sensorsvertically distributed to form a U-shaped array of the probe sensors.

Optionally, the distance between the two adjacent probe sensors is greater than or equal to the horizontal width of one wafer area.

Optionally,the displacement actuating device includes a wafer area switching actuating device and a nanometer displacement actuating device.

Optionally, the wafer area switching actuating device is connected with the moving part of the wafer stage, and is used to drive an area of the wafer to be exposed to be sequentially exposed under the projection exposure area.

Optionally, the moving part of the wafer stagefurther includes a precision movement device, and the nanometer displacement actuating device is the precision movement device.

Optionally, the nanometer displacement actuating device is connected to the exposure beam generating device and/or the precision movement device of the wafer stage, and is used to control the movement of the exposure beam generating device and/or the wafer stage in the vertically and/or vertical and/or circumferential direction.

Optionally, working principle of the nanometer displacement actuating device for driving the exposure beam generating device and/or the precision movement device is at least one of piezoelectric principle, voice coil driving principle or electromagnetic driving principle.

Optionally,the exposure beam emitted by the exposure beam generating device is at least one of light beam, electron beam, ion beam or atomic beam.

Optionally, the exposure beam generating device is a beam generating device, and the beam generating device includes a light source, a shutter, a beam deflector/reflector, a mask plate and a projection objective lens group, the nanometer displacement actuating device is connected to at least one of the beam deflector /reflector, the mask plate and the projection objective lens group, to adjust the position of the projection exposure area of the beam generating device.

Optionally, at least one said probe sensor is fixed on at least one side of the projection objective lens group.

Optionally, the exposure beam is a parallel beam or a Gaussian beam.

Optionally, the shaping and focusing system for the light beam is composed of optical lenses or optical reflectors.

Optionally, the wafer includes a whole wafer, a partial wafer, or a non-wafer material that requires a photolithography exposure treatment.

The application further provides a stepper lithography apparatus for repeated exposure of a plurality of wafer areas within a wafer, said lithography apparatus is provided with a lithography pattern alignment device as described above.

The application further provides an operating method of a stepper lithography apparatus, wherein the method comprises:
preparation step, setting at least one bottom alignment mark on the wafer and coating a photosensitive layer on said wafer to be processed, said bottom alignment mark forming a three-dimensional mark on said photosensitive layer correspondingly;
alignment step, placing the wafer provided with the three-dimensional mark in the preparation step in the lithography apparatus as described above, a projection objective lens group are set close to the wafer in the lithography apparatus, and the projection objective lens group corresponds to a projection exposure area on the wafer, driving the wafer stage to place the first wafer area to be exposed under the projection objective lens group; scanning the photosensitive layer within a certain scanning area by using the probe sensor to obtain the coordinates of position of the first three-dimensional mark, comparing the coordinates of the position of the first three-dimensional mark with the reference coordinates of the first three-dimensional mark to obtain the difference between the two coordinates; the displacement actuating device adjusts the relative position of the exposure beam generating device and the wafer stage according to the difference between the two coordinates, so that the projected exposure area is aligned with the first wafer area.
exposure step, the beam generating device emits an exposure beam to the first wafer area of the wafer to realize the exposure of the first wafer area.

Optionally, the second wafer area is placed under the projection objective lens group after the exposure of the first wafer area is completed, the probe sensor scans coordinates of a position of the first three-dimensional mark having been moved and compares them with the reference coordinates of the first three-dimensional mark having been moved to obtain the deviation of the two coordinates, the displacement actuating device adjusts a relative position of the exposure beam generating device and the wafer stage according to the difference of the coordinates, to align the projected exposure area with the second wafer area and then realizing exposure of the second wafer area.

Optionally, the reference coordinates of the first three-dimensional markhaving been moved are corresponding coordinates in the scanning area, wherein the corresponding coordinates are formed by combining coordinates of said first three-dimensional markwhen the wafer area is exposed with a theoretical distance that the wafer is to be moved to align a next wafer area to be exposed with the projection exposure area.

Optionally, at least one probe sensors are arranged on both sides of the projection objective lens group respectively, or a probe sensor is arranged on one side of the projection objective lens group, and a scan width of the probe sensor is greater than the width of a wafer area to be exposed.

Optionally, the second wafer area is placed under the projection objective lens group after the exposure of the first wafer area is completed, the probe sensor scans coordinates of second three-dimensional mark and compares them with reference coordinates of the second three-dimensional mark to obtain the difference of the two coordinates, the displacement actuating device adjusts relative position of the exposure beam generating device and the wafer stage according to the difference of the coordinates, to align the projected exposure area with the second wafer area and then realizing exposure of the second wafer area, the reference coordinates of the second three-dimensional mark are pre-stored in the computer control system.

Optionally, the first three-dimensional mark is disposed close to the first wafer area, and/or the second three-dimensional mark is disposed close to the second wafer area.

Optionally, the second wafer area is placed under thethe projection objective lens group after the exposure of the first wafer area is completed, the probe sensor scans the graphics and coordinates of the three-dimensional pattern formed on the photosensitive layer after the area of the first wafer is exposed, and compares them with the preset graphics and coordinates of the three-dimensional pattern to obtain the difference between the positions of the two three-dimensional patterns, the displacement actuating device adjusts relative position of the exposure beam generating device and the wafer stage according to the difference of the coordinates, to align the projected exposure area with the second wafer area and then realizing exposure of the second wafer area.

Optionally, the nano probe sensing device is fixed on one or both sides of the projection objective lens group, and relative position between the nano probe sensing device and the projection objective lens group group.

The lithography pattern alignment device of the present invention can be targeted at lithography technologies such as deep and extreme ultraviolet lithography, for example, a UV step-and-repeat exposure lithography (Stepper), which is characterized that the beam passes through the mask to form an exposure pattern and irradiates the wafer coated with the photosensitive layer. Each time one wafer area is aligned and exposed, another wafer area is aligned and exposed by moving the wafer stage, and finally all the wafer areas on the wafer are exposed. Of course, the present invention can also be applied to lithography apparatus for electron beam/photon beam direct writing.

The present invention sets three-dimensional marks on the surface of the wafer, and through one measurement of the wafer, the coordinate relationship between these three-dimensional marks and each wafer area can be fixed, so that the exact coordinate position of the wafer area can be located only by measuring these three-dimensional marks in the future.If the wafer is not deformed due to thermal expansion and contraction through precise temperature control for a relative extended period of time, the positioning between these coordinates can be easily accurate to the single nanometer level.

The first measurement of these 3D marks and the position of the wafer area determines the relative deviation of the wafer relative to the wafer stage, especially if the wafer need to be rotated to adjust the parallelism between the movement of the wafer stage and the array of wafer areas on the wafer when the wafer stage moves.

Unlike scanning electron microscopes, where electron beams can be used to observe and measure patterns on the wafer surface, photon beam lithography apparatus (deep ultraviolet and extreme ultraviolet lithography) do not allow the measurement of wafer patterns to achieve nanoscale resolution due to the wavelength of the exposure photons used, therefore, the photon beam cannot participate in the alignment and positioning of single nanometer and below dimensional accuracy. However, the technical solution of the present invention can make the positioning accuracy of the photon beam lithography apparatus reach the nanometer and sub-nanometer level.

The closer the three-dimensional marks are to the area of the wafer that is being exposed, the higher the alignment accuracy for the area of the wafer. Three-dimensional marks are set between wafer regions or inside wafer regions, and this is the type for a step-and-repeat exposure lithography apparatus. If the three-dimensional marks placed inside the wafer area can be as small as a few nanometers to hundreds of nanometers, it will be very practical because it occupies a small area, then even if three-dimensional marks are made in the wafer area, it will not affect the yield of the wafer area.

The present invention adopts measurement technology capable of perceiving three-dimensional nanoscale structures, such as the use of probe sensor sensing technology to realize sub-nanometer three-dimensional shape measurement technology (sub-nano-level atomic force three-dimensional shape measurement technology), then the nanoscale three-dimensional mark can be measured by the probe sensor sensing technology to play the role of nanoscale coordinates. The three-dimensional marks on the photosensitive layer and the surface of the wafer can be used as alignment marks, such as measuring the peak position or the concave position of the three-dimensional mark to determine an accurate alignment coordinate. The concave-convex structure on the wafer surface causes the surface of the photosensitive layer covering it to follow to form a concave-convex structure, that is, the positioning can penetrate vertically, so that the surface covering the photosensitive layer can be measured due to its concave-convex structure and position. The sensor technology of the probe sensor adopted in the present invention can make the optical measurement reach the sub-nanometer level measurement.

In addition to using the three-dimensional marks described above to position the wafer, the present invention can also position the exposure of the wafer area according to the characteristics of the radiation-induced modification of the photosensitive layer. Irradiation Induced Resist Change (IIRC) refers to changes in the chemical and/or physical properties of the photosensitive layer at the location where photon beams or electron beams or other particle beams are irradiated and exposed. Chemical changes include photon beams/electron beams causing chemical reactions on the surface of the photosensitive layer, causing the irradiated part of the photosensitive layer to change from an insoluble state to a dissolved state during development (positive photoresist), or a dissolved state to become insoluble through exposure (negative photoresist). Photon beam/electron beam exposure can also cause physical changes in the photosensitive layer, including small geometric changes on the surface of the photosensitive layer, such as swelling or shrinking on the sub-nanometer or nanometer scale to form a concave-convex structure. When the photon beam/electron beam exposure transfers the exposure pattern to the photosensitive layer, the concave-convex structure change on the photosensitive layer also occurs. This deformation can be sensed by measuring on the sub-nanometer scale with a probe sensor (an extremely sensitive sensor head).

The advantages of the present invention are:
1. Provide a new technology for lithography apparatus that can measure the actual position of wafer area graphics with sub-nanometer precision;
2. Provide a variety of methods and devices for correcting the nanoscale movement between the coordinate positions of the exposure photon beam/electron beam relative to the coordinate position of the wafer area/writing field;
3. Provide an (extreme) ultraviolet optical lithography apparatus with ultra-high overlay alignment accuracy in the wafer area;
4. Provide a combined horizontal and vertical alignment stitching error correction and exposure method and device for the wafer area/writing field in a lithography apparatus based on the principle of closed-loop control.

### Description of drawings

To illustrate the technical solution of the present invention more clearly, the accompanying drawings that need to be used in the description of the technical solution of the present invention are briefly introduced below. It is obvious that the following drawings are only some embodiments of the invention and that other embodiments based on the inventive ideas shown in these drawings are within the scope of protection of the invention for a person of ordinary skill in the art, without any creative work.
FIG. 1 shows a schematic diagram of a device for aligning lithographic patterns of the present invention.
Figure 2 shows a schematic structural diagram of a lithography apparatus in a specific embodiment.
FIG. 3 shows a schematic diagram of the positions of the three-dimensional marks on the wafer.
FIG. 4A is a schematic diagram of a three-dimensional mark with a convex surface; FIG. 4B is a schematic diagram of a three-dimensional mark with a concave surface; FIG. 4C is a schematic diagram of a three-dimensional mark with a concave-convex surface; and FIG. 4D is a schematic diagram of a three-dimensional structure of a three-dimensional mark.
FIG. 5A is a schematic diagram of the radiation-induced swelling structure of the photosensitive layer; FIG. 5B is a schematic diagram of the radiation-induced shrinkage structure of the photosensitive layer.
FIG. 6 shows a schematic structural diagram of a lithography apparatus according to another embodiment of the present invention.
FIG. 7 shows a schematic structural diagram of a lithography apparatus according to another embodiment of the present invention.
FIG. 8 shows a schematic diagram of the corresponding relationship between a plurality of probe sensors and wafer areas according to an embodiment of the present invention.
FIG. 9 shows a schematic diagram of the corresponding relationship between the probe sensor and the wafer area according to another embodiment of the present invention.
FIG. 10 shows a schematic diagram of the corresponding relationship between the probe sensor and the wafer area according to another embodiment of the present invention.

### Embodiments

The inventive concepts and technical solutions of the present invention will be described in detail below in conjunction with the accompanying drawings.

In the field of step-and-repeat exposure lithography apparatus, after the exposure of a wafer area is completed, the wafer moves to the next wafer area through the movement of the wafer stage for overlay alignment, and then exposure. At present, the alignment of the lithography apparatus mainly realizes the alignment of the wafer area on the wafer with the beam projection exposure area through the precise positioning of the wafer stage. This alignment introduces positioning errors due to wafer stage movement, and the alignment error caused by the beam offset cannot be corrected in time. The entire positioning process belongs to the open-loop control state without coordinate measurement before positioning and without coordinate measurement after positioning. There is no real-time measurement of the alignment error and no feedback information using the alignment error. This error is generally several nanometers or even tens of nanometers.

The precision of the laser interference stage can be obtained by processing the high power of the light wavelength of laser interference to the precision of several nanometers. The actuating device of the wafer stage can be a piezoelectric driving mode or even a voice coil driving mode. Its mobile positioning accuracy can reach sub-nanometer or even picometer level. The problem is that the position obtained by laser interferometry is the distance of the optical path, not necessarily the distance that the actual wafer stage needs to move. As long as there is a slight temperature change around the wafer stage or the beam, the change of air concentration and air pressure will cause the optical path difference and the actual distance to be inconsistent, so that the distance measured by the laser is not the actual distance that the wafer stage needs to move. Moreover, the multiple movements of the laser stage will accumulate the error of each movement, thereby amplifying the error. The inventors of the present invention have found that it is very difficult to measure single-nanometer and sub-nanometer accuracy even with the most accurate laser interference correction mechanism, and even if the correction is successful, it is accidental.

In addition, studies have found that some deep ultraviolet and extreme ultraviolet optical lithography apparatus have a laser interference positioning mechanism between the wafer and the exposure beam, that is, the part of the lithography apparatus that is connected to the exposure beam on one side of the wafer is formed, and the mutual positioning is formed on this side through laser interference. This is a closed loop control system. On the wafer area, a grating structure is arranged in the middle of the wafer area. The laser is emitted from the part of the lithography apparatus connected to the exposure beam to the grating structure in the middle of the wafer area, and then return to the part of the lithography apparatus where the exposure beam is connected to form interference with the emitted laser, or form a double grating interference with the grating on one side of the exposure beam. The movement of the interference fringes corresponds to the relative movement between the wafer area and the exposure beam. The positioning accuracy achieved by this method is feasible at the order of 20 nanometers or even several nanometers. But once it enters one nanometer or even sub-nanometer positioning, the drift and shake of its interference fringes will greatly affect the determination of actual positioning.

For this reason, the present invention discloses a technical solution that can accurately position a wafer and achieve alignment between the wafer area to be exposed and the projected exposure area based on the positioning result. This technical solution can find the positioning error in the wafer area, and then solve and eliminate the positioning error problem to achieve sub-nanometer alignment and overlay.

Embodiments of the present invention provide an apparatus and method for sub-nanometer overlay alignment of an optical lithography apparatus, and an application scene on a lithography apparatus system. In the present invention, the wafer stage is used as a rough positioning for overlaying and aligning the wafer area on the wafer of the lithography apparatus with the projection exposure area. The detailed overlay alignment and positioning is carried out after measuring the positioning error and implementing error compensation. In the present invention, this subtle error compensation can be realized with a sub-nanometer displacement actuating device. The present invention solves the sub-nanometer level displacement of the driving object and the alignment method to achieve a huge improvement in sub-nanometer level overlay alignment accuracy between the chip area on the wafer and the projected exposure area. The wafer comprises a number of wafer regions 120 and an off-site region 122 surrounding the wafer regions, at least one underlying alignment mark is set on the wafer, and a photosensitive layer 130 is set on the surface of the wafer, the underlying alignment marks form corresponding three-dimensional marks on the photosensitive layer, the three-dimensional marks have regions that are not at the same level as the upper surface of the photosensitive layer. The three-dimensional mark of the present invention includes the three-dimensional mark formed on the photosensitive layer by the bottom alignment mark pre-set on the wafer and includes the three-dimensional pattern three-dimensional mark formed on the photosensitive layer according to the characteristics of radiation-induced modification of the photosensitive layer.

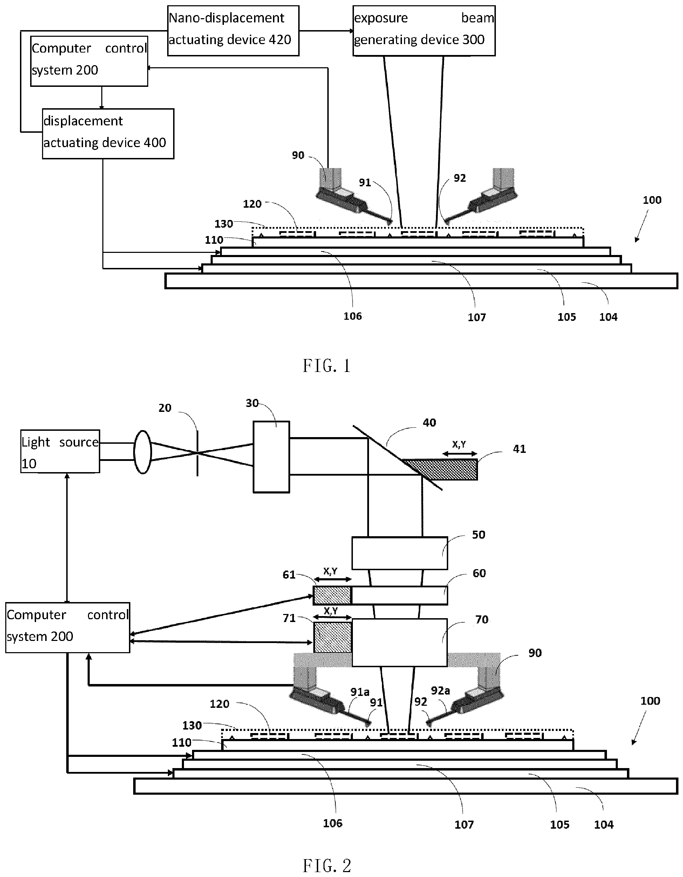

Fig. 1 shows the schematic diagram of a kind of lithography pattern alignment device of the present invention, and described alignment device is positioned at a lithography apparatus, and described lithography apparatus comprises: A wafer stage 100, used to carry the wafer 110 to be processed, the lithography apparatus involved in the present invention is a stepper lithography apparatus, which achieves the purpose of sequentially exposing different wafer areas of the wafer by gradually moving the wafer stage. A nano probe sensing device 90 is arranged above the wafer stage, and the nano probe sensing device includes at least one probe sensor 91, the probe sensor is located above the photosensitive layer, and is used to move in a certain scanning area to scan and determine the coordinates of the three-dimensional marks in this area and/or the three-dimensional pattern three-dimensional marks formed on the wafer area.

The exposure beam generating device 300 is arranged above the wafer, and the exposure beam generating device is used to provide the exposure beam required for the exposure of the wafer area, and the exposure beam forms a projected exposure area on the wafer; in addition, the alignment device of the present invention also includes a displacement actuating device 400, configured to adjust the relative position of the exposure beam generating device and the wafer stage according to the three-dimensional mark coordinates measured by the probe sensing device, so that the projected exposure area is aligned with the area of the wafer to be exposed.

The lithography pattern alignment device shown in FIG. 1 also includes a computer control system 200, the computer control system 200 is used to receive the coordinates of the three-dimensional mark measured by the nano probe sensing device and compare them with the reference coordinates of the three-dimensional mark to obtain the displacement difference of two coordinates in the horizontal, vertical or circumferential direction, the displacement difference of two coordinates in the circumferential direction refers to the displacement difference of the three-dimensional mark in the circumferential direction; the computer control system is used to transmit the difference to the displacement actuating device 400, and the displacement actuating device 400 control the exposure beam generating device and/or the wafer stage to move relative to each other to compensate for the difference.

The reference coordinates described in the present invention are the coordinates within a certain scanning area that are pre-stored in the computer control system by each three-dimensional mark, or the coordinates measured by said nano probe sensing device for said three-dimensional mark before the exposure of that wafer area and corresponding to the realization of the next wafer area to be exposed and the projection exposure area aligned with theoretical distance the wafer is to be moved combined in said scanning area, theoretically, the distance to be moved by the wafer in the horizontal and vertical directions is pre-stored in the computer control system. If the three-dimensional mark is a three-dimensional pattern on the surface of the photosensitive layer due to irradiation-induced photosensitive layer degeneration, the reference coordinates of the three-dimensional mark are the three-dimensional pattern of the wafer area that has been exposed, and the parameters such as graphics and coordinates in the scanning area are pre-stored in the computer control system.

The exposure beam emitted by the exposure beam generating device of the present invention is at least 300
one of light beam, electron beam, ion beam or atomic beam, and the present invention mainly uses an optical lithography apparatus as an example for introduction.

FIG. 2 shows a schematic structural diagram of a lithography apparatus in a specific embodiment, specifically a schematic diagram of a sub-nanometer step-by-step repetitive exposure optical photolithography apparatus. Its optical lithography apparatus system mainly consists of the following parts:
The beam generating device includes a light source 10, a shutter 20, a beam shaping system 30, a beam deflector/reflector 40, a shaping lens group 50, a mask plate 60 and a projection objective lens group 70. The computer control system 200 of the lithography apparatus can control the shutter 20 and determine the exposure time of the light source.

Wafer stage 100, used to carry wafer 110 to be processed, the wafer includes several wafer areas 120, and several three-dimensional marks are set on the wafer (detailed description later). The wafer stage 100 includes a moving part and a fixed part, wherein the moving part comprises a wafer area switching actuating device 105 and a precision moving device 106, the fixed part 104 of the wafer area switching actuating device is located below the wafer area switching actuating device 105, used to carry the wafer area switching actuating device 105 and drive the wafer to move step by step to expose different wafer areas under the beam generating device in sequence. The computer control system 200 is connected with the wafer area switching actuating device 105 which controls the precise movement of the wafer stage and is used to drive the wafer to move step by step to realize the exposure of all wafer areas. The wafer area switching actuating device has a large displacement range, and the wafer area switching actuating device has a moving distance above the micron level, at present, the movement of some relatively precise wafer area switching actuating devices can be controlled within 10 nanometers or even to a positioning accuracy of 2.5 nanometers. The precision moving device 106 is located above the fixing device 107, and the fixing device 107 is placed above the wafer area switching actuating device 105, the precision moving device 106 can fine-tune the position of the wafer in the horizontal, vertical or circumferential directions at the sub-nanometer level. The setting of the precision moving device can reduce the dependence of wafer positioning on the accuracy of wafer stage movement, thus allowing the use of a wafer stage with lower mobile positioning accuracy.For example, a wafer stage with a positioning accuracy of 1 nm can be replaced by a wafer stage with a positioning accuracy of 1000 nm, which greatly reduces the cost of the wafer stage.

The nano tip sensing device 90 includes probe sensors 91 and 92 and micro cantilevers 91a and 92a connected to the probe sensors, the probe sensor is located above the photosensitive layer of the wafer, and is used to scan in a certain scanning area and determine the coordinates of the three-dimensional marks in the area, and the obtained signal is transmitted to the computer control system 200 for comparison with the reference coordinates. The nano probe sensing device can be fixed on a component that is close to the wafer but does not affect the positioning of the exposure beam, in this embodiment, the probe sensors 91 and 92 are fixed on the lens side of the projection objective lens group 70. The probe sensor moves with the photon beam, and of course the probe sensor also drifts with the photon beam. The advantage of this is that the micro cantilever of the probe sensor can be made very short, thereby improving the resolution of the three-dimensional measurement of the probe sensor.

In the structural diagram of the lithography apparatus shown in FIG. 2, the probe sensors 91 and 92 fixed on the beam projection objective lens group 70 are respectively placed on both sides of the beam projection objective lens group, that is, one or one row on each side, forming a situation where the areas on both sides of the projection exposure area that can cover the wafer area are measured, that is, each or each row of probe sensors corresponds to both sides of the wafer area in the projection exposure area, and can measure off-field three-dimensional marks between wafer areas on both sides of the wafer area. Each or each row of probe sensors is fixed on the beam projection objective lens group, so that the distance between them is fixed, therefore, the mutual coordinates are also fixed. The probe sensors are set on both sides of the wafer area, which has the advantage of greatly reducing the scanning range of each probe sensor, That is, it only needs to scan the middle of each wafer area, instead of scanning the entire wafer area from the middle of the wafer area at one end to the middle of the wafer area on the other side of the wafer area, thus greatly improving the linearity and positioning accuracy of the probe sensor scanning.

The displacement actuating device 400 includes the wafer region switching actuating device 105 and the nanometer displacement actuating device 420 for driving the stepwise switching of the wafer region. The nanometer displacement actuating device 420 is connected with the computer control system 200, according to the coordinates of the bottom alignment mark measured by the nano probe sensor 90, the light beam generating device and/or the fine adjustment of the position of the wafer workstage are controlled to realize the overlay alignment of the area of the wafer to be exposed and the exposure beam emitted by the beam generating system and complete the exposure. In this embodiment, the nanometer displacement actuating device 420 can selectively drive at least one of the reflectors 40, the shaping lens group 50, the mask plate 60, the projection objective lens group 70 or the wafer workstage 100 to move, to achieve fine-tuned alignment of projected exposure area and wafer area to be exposed.

In this embodiment, a nanometer displacement drive device 61 is installed on the mask work stage 60 to realize horizontal movement of the mask, alternatively, a nanometer displacement drive 71 capable of pushing a horizontally moving lens is installed around the optical projection objective set 70, or horizontally move the photon beam/electron beam or the nanometer displacement actuating device 41 of the deflection device 40. Selecting any one of the above-mentioned nanometer displacements actuating devices can realize the fine adjustment of the position of the projected exposure area. Optionally, more than one nanometer displacement actuating devices can be arranged on the above-mentioned components.

To set three-dimensional marks on the wafer, so as to use the three-dimensional marks on the wafer to realize the alignment of the wafer area to be exposed and the projected exposure area of the wafer, it is necessary to set appropriate three-dimensional marks on the wafer. The details will be described below.

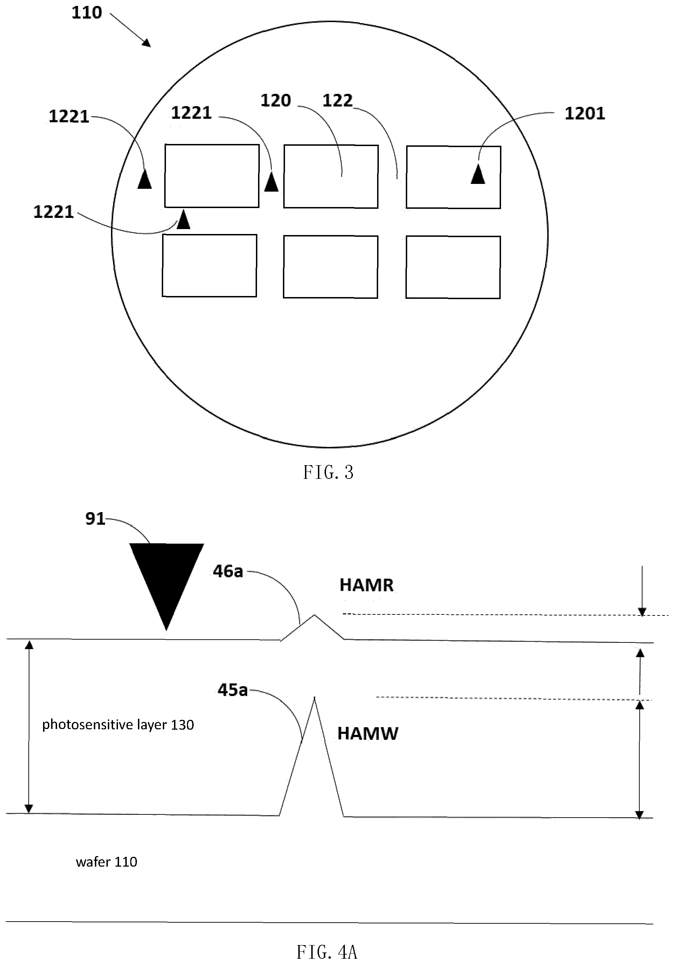

FIG. 3 is a schematic diagram of the positions of preset three-dimensional marks on the wafer. The wafer 110 includes a wafer area 120 exposed to form a three-dimensional pattern and an off-site area 122 disposed on the periphery of the wafer area. A three-dimensional mark can be placed in the area of the wafer, and the three-dimensional mark is called an on-site three-dimensional mark 1201; it can also be set in the off-site area, this three-dimensional mark is called an off-site three-dimensional mark 1221, which can be set in the middle zone between adjacent wafer areas or in the wafer edge area. The benefit of off-site 3D mark is that even destructive processing of these marks will not impact wafer area yields. These marks can be used as alignment coordinate marks by photon beam/electron beam exposure and can be repeatedly "observed" with photon beam/electron beam, i.e., exposed.

On-site three-dimensional mark 1201 includes nanoscale three-dimensional marks that are preset before the first processing procedure in the wafer area, or it can be a three-dimensional pattern produced by the photosensitive layer coated on the wafer and on the surface of the wafer area after light beam exposure 3D marks. The on-site three-dimensional mark 1201 can be as small as a few nanometers to hundreds of nanometers, because it occupies a small area, even making marks in the wafer area will not affect the wafer area yield problem.

Through one measurement of the wafer, the coordinate relationship between these three-dimensional marks and each wafer area can be fixed, and the accurate coordinate position of the wafer area can be located only by measuring these three-dimensional marks in the future.Assuming that the wafer is not deformed due to thermal expansion and contraction through precise temperature control for a relatively long period of time, the positioning between these coordinates can be easily accurate to the single nanometer or sub-nanometer level.

The first measurement of these 3D marks and the position of the wafer area determines the relative deviation of the wafer relative to the wafer stage, especially if the wafer need to be rotated to adjust the parallelism between the movement of the wafer stage and the array of wafer areas on the wafer when the wafer stage moves. The computer control system 200 controls each component of the lithography apparatus through the off-site three-dimensional mark and on-site three-dimensional marks of the wafer area and realizes sub-nanometer vertical overlay alignment and exposure of the wafer area through a preset control method.

The closer the three-dimensional marks are to the area of the wafer that is being exposed, the higher the alignment accuracy for the area of the wafer. Three-dimensional marks 1221 between wafer regions are set between wafer regions. The setting of this three-dimensional mark is suistage for a step-and-repeat exposure lithography apparatus. However, for non-mask type direct writing photon beam/electron beam lithography apparatus, there are actually many cases where it is not allowed to leave a space between the exposed writing fields, gratings or Fresnel lenses as examples.

The present invention adopts measurement technology capable of perceiving three-dimensional nanoscale structures, such as the use of probe sensor sensing technology to realize sub-nanometer three-dimensional shape measurement technology (sub-nano-level atomic force three-dimensional shape measurement technology). The present invention sets a three-dimensional mark on the wafer, and the three-dimensional mark realizes coordinate positioning through the measurement of the probe sensor sensing technology. The three-dimensional marks on the photosensitive layer and the surface of the wafer can be used as alignment marks, such as measuring the peak position or the concave position of the three-dimensional mark to determine an accurate alignment coordinate. The concave-convex structure on the wafer surface generally causes the surface of the photosensitive layer covering it to follow to form a concave-convex structure, that is, the positioning can penetrate vertically, so that the surface covering the photosensitive layer can be measured due to its concave-convex structure and position.

Wafer according to the present invention includes several wafer areas, at least one bottom layer alignment mark is provided inside or around the wafer area, a photosensitive layer is provided on the surface of the wafer, and the underlying alignment mark forms a corresponding three-dimensional mark on the photosensitive layer, the three-dimensional mark has a region that is not at the same level as the upper surface of the photosensitive layer.

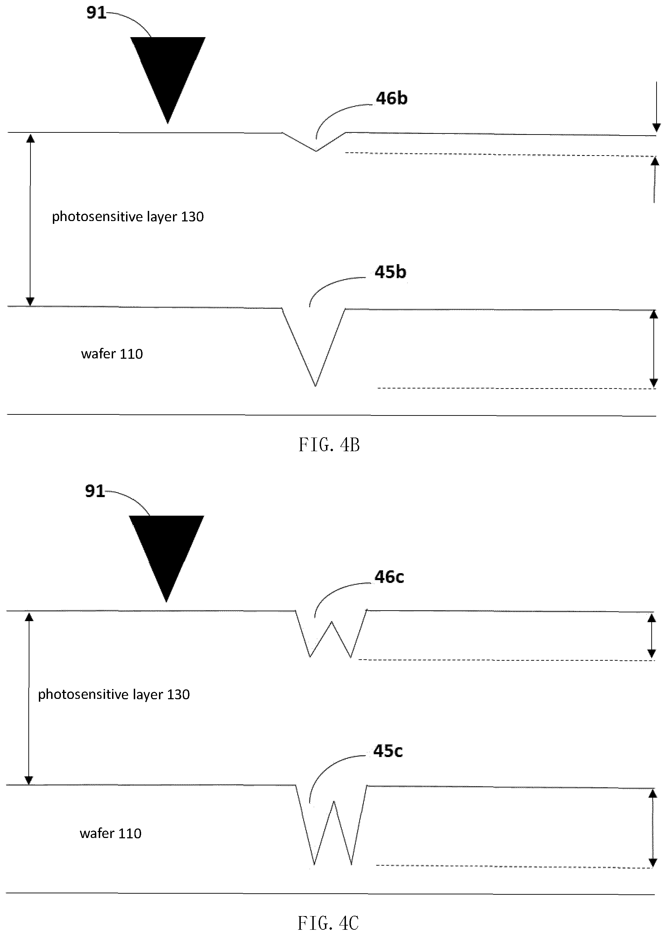

Fig. 4A, Fig. 4B and Fig. 4C show the specific implementation manner of setting three-dimensional marks on the wafer, respectively.

Figure 4A shows a schematic diagram of a convex three-dimensional mark. Firstly, more than one bottom alignment protruding mark 45a (HAMW) is set on the wafer by methods such as deposition, it is this preset nano-level bottom alignment mark,then set the photosensitive layer on the wafer, because the photosensitive layer has certain fluidity and soft texture, this bottom alignment protruding mark 45a (HAMW) will form a corresponding protruding structure 46a (HAMR) on the upper surface of the photosensitive layer, which is the three-dimensional mark described in the present invention. If the thickness of the photosensitive layer is between 10 nanometers and 100 nanometers, the surface layer of the photosensitive layer above the wafer bottom alignment mark 45a (HAMW) will also become a three-dimensional mark. The height of the three-dimensional mark can range from several nanometers to tens of nanometers, usually less than 100 nanometers, which accurately gives its position as a three-dimensional mark on the surface of the photosensitive layer. This position is exactly equivalent in the vertical direction to the position of the alignment mark on the bottom layer of the wafer vertically below. In this way, it can accurately determine the horizontal coordinates of the wafer pattern, and it is important that this horizontal coordinate can be set within the wafer area (writing field). The placement of these three-dimensional marks enables the accuracy of the alignment to be determined such that the alignment does not depend on the movement accuracy of the wafer stage. This allows the use of a wafer stage with a low positioning accuracy for movement. For example, a wafer stage with a positioning accuracy of 1 nm can be replaced by a wafer stage with a positioning accuracy of 1000 nm, which greatly reduces the cost of the wafer stage.

At least some areas of the three-dimensional mark and the photosensitive layer of the present invention are located on different horizontal planes. For example, in this embodiment, the three-dimensional mark 46a has a dot-form protrusion protruding from the photosensitive layer, when a wafer with this three-dimensional mark is placed in the lithography apparatus of the present invention, the probe sensor of the nano probe sensing device scans within a certain scanning area, due to the extremely weak repulsive force between the atoms of the probe sensor and the atoms on the wafer surface, the micro cantilever will fluctuate in the direction perpendicular to the wafer surface corresponding to the equipotential plane of the force between the probe sensor and the wafer surface atoms. The position change of the micro cantilever corresponding to each scanning point can be measured by using the optical detection method or the tunnel current detection method, to obtain the information of the surface topography of the wafer. In the present invention, the three-dimensional mark has dot-form protrusions, the distance from the dot-form protrusion to the probe sensor is different from the distance from the upper surface of the photosensitive layer to the probe sensor, to realize the positioning of the three-dimensional mark when the probe sensor scans. To accurately identify the coordinates of the three-dimensional mark, the height of the three-dimensional mark set in the present invention is greater than the surface roughness of the photosensitive layer, and an optional height is less than or equal to 50 microns.

FIG. 4B illustrates a schematic diagram of a structure where the three-dimensional marks on the wafer surface are recessed sections, and additional material is required on the wafer to achieve the three-dimensional protruding structure shown in FIG. 4A. In contrast, the wafer is etched to form an inverted three-dimensional "protruding" structure 45b, that is, a recessed structure, its advantage is that it does not need to deposit additional material on the wafer, but "digging" the material of the existing wafer, which is easier than manufacturing a three-dimensional protrusion structure. According to the above description, the three-dimensional mark 46b corresponding to the depression is formed on the photosensitive layer, since the probe sensor of atomic force microscope can measure the entire 3D structure, even if the pit of the 3D structure is several nanometers in size at its tip, all the 3D topography information of the structure can improve the localization to the single nanometer level.

FIG. 4C is a schematic diagram of a nanoscale concave-convex three-dimensional mark structure etched on the wafer surface by etching technology. Its advantage is that it does not need to add other materials to be deposited on the wafer, and it can also obtain a three-dimensional protruding structure as a nanoscale three-dimensional mark. In this embodiment, the bottom alignment mark 45c on the wafer includes more than one dot-form structure, and the three-dimensional mark 46c on the corresponding photosensitive layer also has more than one dot-form structure, so that the probe sensor can achieve more precise positioning.

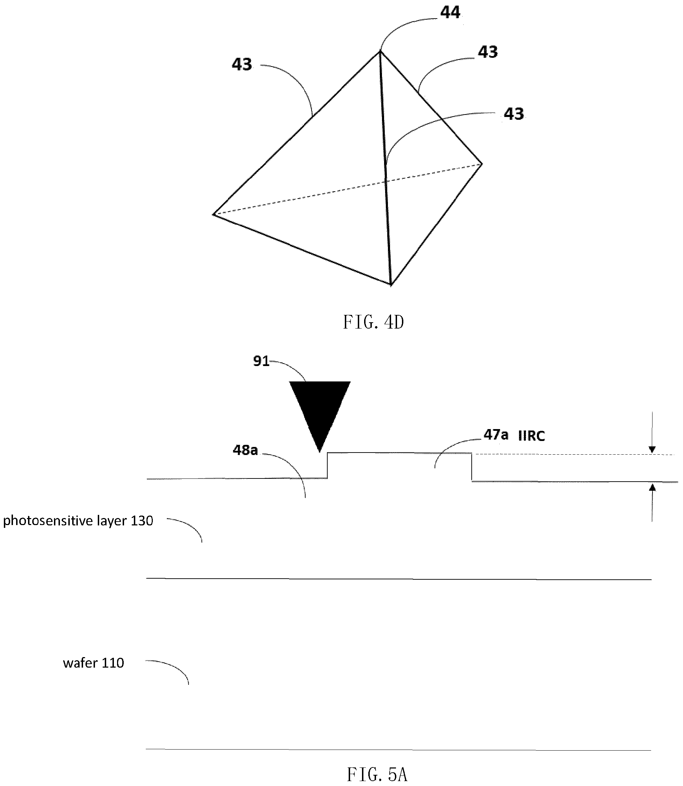

In order to realize accurate positioning of the wafer coordinates with a single three-dimensional mark, the three-dimensional mark described in the present invention may optionally have certain graphic features. In addition to including at least one dot-form feature 44, the graphic feature also includes a ridge line feature 43 connected to the dot-form feature, the dot-form features and ridge line features are not completely located in the same plane as the upper surface of the photosensitive layer. Figure 4D shows a schematic diagram of a three-dimensional prismatic structure, which increases the detecstage area of the three-dimensional mark and improves the positioning accuracy of the three-dimensional mark by adding several ridge line features 43 located in different horizontal planes from the photosensitive layer.

In the above embodiments, a protruding or concave nanometer three-dimensional structure, such as a micro-cone, a micro-pyramid, or a micro-probe sensor, is preset on the surface of the wafer. Its diameter scales from a few nanometers to tens of nanometers, usually less than 100 nanometers. These microstructures can be achieved by plasma etching or electron beam induced deposition (EBID).

The present invention can set multiple three-dimensional marks on the wafer. An optional way is to set at least one three-dimensional mark corresponding to each wafer area, the three-dimensional mark can be an on-site three-dimensional mark arranged inside the wafer area, or an off-site area three-dimensional mark arranged around the wafer area. The periphery of the wafer area includes an off-site area between two horizontally adjacent or two vertically adjacent wafer areas, or an off-site area where the edge of the wafer corresponds to the wafer area, etc., optionally, the coordinates of the three-dimensional mark corresponding to each wafer area are fixed relative to the wafer area. The three-dimensional marks shown in FIGS. 4A-4D described above are three-dimensional marks for setting absolute positions on the wafer, in addition, depending on the characteristics of the photosensitive layer, the wafer can be positioned by using the tip sensing technology according to the shape of the specific photosensitive layer after exposure, to improve overlay accuracy of wafer areas through positioning of these relative marks.

The underlying alignment marks mentioned above include marks made on the surface of the wafer before the first exposure of the wafer, and include the marks arranged under the photosensitive layer in the subsequent exposure process. Considering that the possible loss of the 3D mark during the graphic transfer process leads to the weakening of the dot-form features and ridge features of the 3D mark, the underlying alignment mark can be remade to improve the positioning accuracy of the subsequent three-dimensional mark on the surface of the photosensitive layer after a certain process is carried out.

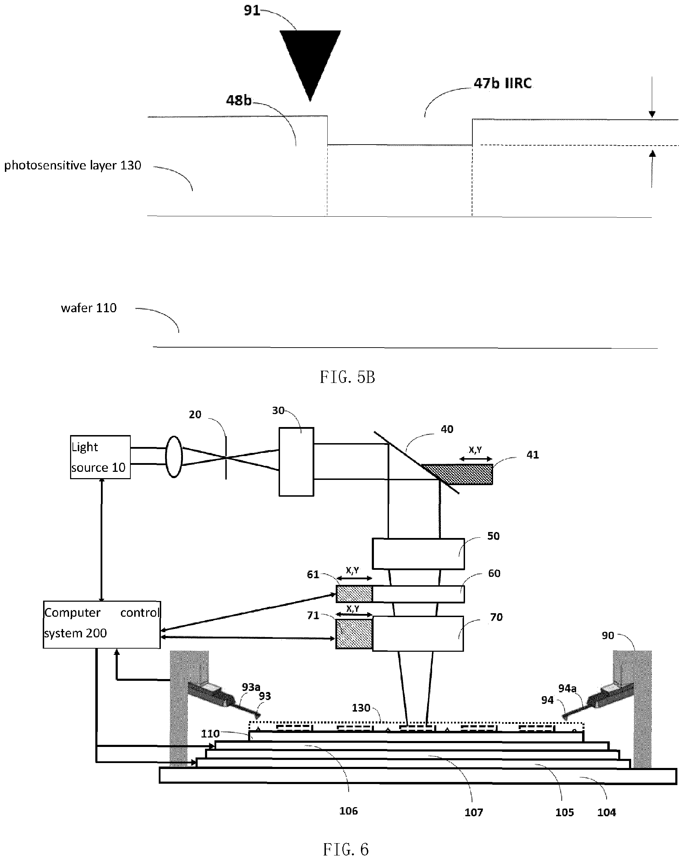

Figure 5A shows a schematic diagram of pattern by using Irradiation Induced Resist Change (IIRC). Irradiation Induced Resist Change (IIRC) refers to changes in the chemical and/or physical properties of the photosensitive layer at the location where photon beams or electron beams or other particle beams are irradiated and exposed. Chemical changes include photon beams/electron beams causing chemical reactions on the surface of the photosensitive layer, causing the irradiated part of the photosensitive layer to change from an insoluble state to a dissolved state during development (positive photoresist), or a dissolved state to become insoluble through exposure (negative photoresist). Photon beam/electron beam exposure can also cause physical changes in the photosensitive layer, including small geometric changes on the surface of the photosensitive layer, when the photon beam/electron beam exposure transfers the exposure pattern to the photosensitive layer, the concave-convex structure change on the photosensitive layer also occurs. For example, the exposed area expands on the sub-nanometer level or nanometer level, forming a convex area 47a relative to the unexposed area 48a, see FIG. 5A; or the exposed area shrinks to form a recessed structure, see Figure 5B, forming a recessed area 47b and an unexposed area 48b. The probe sensing technology can realize the positioning of a certain wafer area by measuring the convex area 47a and the concave area 47b. This deformation can be sensed by probing at the sub-nanometer scale with a probe sensor (highly sensitive sensor head).

In order to ensure the accuracy of positioning using the IIRC marks shown in Figure 5A and Figure 5B, several three-dimensional marks can be set on the edge of the wafer, for example, three or more three-dimensional marks are set, and the position of the entire wafer is determined through the three-dimensional marks. The absolute position of the wafer is then measured and positioned by the probe sensor. A combination of multiple probe sensors can be used here, for example, a linear array of multiple probe sensors can be used to transfer the coordinates of these absolute 3D marks located at the edge of the wafer to the middle of the wafer. The linear probe sensors array greatly expands the range over which the probe sensors can measure wafers without errors. The mutual distance between the probe sensors on the one-dimensional linear probe sensors array is fixed. The movement of the probe sensor moves the line array uniformly through the piezoelectric displacement at both ends of the line array or the voice coil drive system. Therefore, the relative coordinate positions between the probe sensors remain unchanged.

In addition to using the three-dimensional pattern three-dimensional marks produced by the exposure of the wafer area itself to align the exposure of the subsequent wafer area, a positioning mark generating device (not shown in the figure) can also be provided on the exposure beam generating device. The positioning mark generating device forms a three-dimensional positioning mark on the periphery of the wafer area while the wafer area is exposed, and the probe sensor performs positioning and calibration on the position of the wafer area to be exposed according to the three-dimensional positioning mark. For example, in an optical lithography apparatus system, one or more positioning mark generating devices can be arranged on the periphery of the normal pattern of the mask plate. When exposing a wafer area to be exposed, a three-dimensionalmark is exposed at the edge of the wafer area at the same time. The three-dimensionalmark is optionally located between the two wafer areas to reduce the scanning area of the probe sensor and improve the efficiency of positioning. When exposing the area of the next wafer, the computer control system 200 aligns the area of the wafer to be exposed with the projected exposure area by using the nanometer displacement drive device according to the coordinates of the three-dimensionalmark corresponding to the area of the previous wafer scanned by the probe sensor.

FIG. 6 shows a schematic structural diagram of a lithography apparatus according to another embodiment of the present invention. In this embodiment, the nano probe sensing device is arranged on the wafer stage 100, wafer stage 100 includes a moving part and a fixed part, and the probe sensors 93 and 94 are connected to the fixed part through the micro-cantilevers 93a and 94a, respectively.

The alignment method of this embodiment is to first measure the three-dimensional marks provided between the wafer regions, and/or measure the pattern structure and coordinate position of the wafer region in the wafer region before exposure. After exposure, the wafer area switching actuating device 105 drives the wafer stage 110 to move horizontally, freeing up the projected exposure area for the next wafer area for exposure, while the movement also brings about writing field movement errors. The new coordinates of the 3D marks on the surface outside and/or inside the wafer area resulting from the wafer stage movement are measured by the probe sensor and compared with the coordinates of the original 3D marks to give the XY coordinates (and XY plane angle) of the wafer area movement error. This amount can be given to the wafer stage as a repositioning, or to the objects that affect the photon beam such as mask plates or projection objective sets to move by several nanometers. In this embodiment, since the probe sensor sensing technology is set on the wafer stage, it is convenient to measure the three-dimensional marks in the edge area of the wafer. Due to the large distance between the 3D marks in the edge area of the wafer, only a few 3D marks are needed to determine the exact position of the entire wafer.

The problem with this method and device is that the size of the wafer stage is large, generally more than 200 mm. In this way, the micro cantilever connecting the probe sensor head with the base of the fixed probe sensor will be very long. A very long micro cantilever may reduce the resolution of the three-dimensional measurement of the surface of the probe sensor, so this embodiment can be improved.

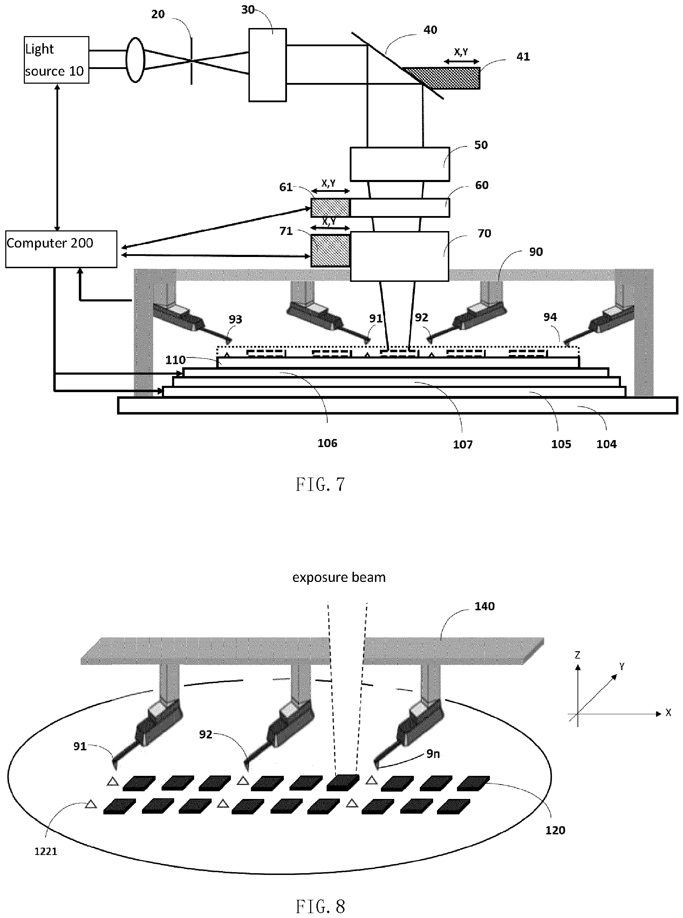

Fig. 7 shows a schematic structural diagram of a lithography apparatus according to another embodiment of the present invention. In this embodiment, the nano probe sensing device combines the features of fixed positions in FIG. 2 and FIG. 6. One set of probe sensor heads 93 and 94 are fixed on the wafer workstage, and the other set of probe sensor heads 91 and 92 are fixed on one side of the photon beam, such as the two sides of the projection objective lens group.The advantage of this is that it can accurately measure the coordinates of the off-site 3D marks corresponding to the area of the wafer to be exposed, and at the same time, the exact position of the entire wafer can be determined only through a few 3D marks.

FIG. 8 shows a schematic diagram of the corresponding relationship between a plurality of probe sensors and wafer areas according to an embodiment of the present invention. The coordinate position of each wafer area is measured and determined by the plurality of probe sensors. In this embodiment, the plurality of probe sensors 91, 92, ... 9n are fixedly connected by a connecting piece 140, according to the distribution of the wafer area, they are arranged in a row horizontally to form a horizontal probe sensor array. According to the foregoing description, in the preparation step, at least one underlying alignment mark is set on the wafer to be processed, and the underlying alignment mark forms a three-dimensional mark on the photosensitive layer correspondingly; When exposing the wafer, the wafer provided with the three-dimensional mark in the preparation step is placed in the lithography apparatus described above, a projection objective lens group 70 is arranged close to the wafer in the lithography apparatus, and the projection objective lens group corresponds to a projection exposure area on the wafer, the wafer area switching actuating device 105 that drives the wafer workstage places the first wafer area to be exposed under the projection objective lens group; Use at least one of the probe sensors 91-9n to scan the photosensitive layer in a certain scanning area to obtain the position coordinates of the first three-dimensional mark, for example, the three-dimensional mark 1221, comparing the position coordinates of the first three-dimensional mark with the reference coordinates of the first three-dimensional mark to obtain the difference between the two position coordinates; the displacement actuating device adjusts the relative position of the exposure beam generating device and the wafer stage according to the difference between the two position coordinates, so that the projected exposure area is aligned with the first wafer area, the light beam generating device emits an exposure beam to the first wafer area of the wafer to realize the exposure of the first wafer area. The reference coordinates of the first three-dimensional mark are pre-stored in the computer control system, and when the three-dimensional mark is located at the reference coordinates, the first wafer area is aligned with the projected exposure area.

After the exposure of the first wafer area is completed, the second wafer area is placed under the projection objective lens group, at this time, various alignment marks may be used to align the region of the first wafer with the projected exposure region. One alignment method is: the probe sensor scans the moved position coordinates of the first 3D mark and compares it with the moved reference coordinates of the first 3D mark to obtain the deviation of the two position coordinates, the reference coordinates of the first three-dimensional mark after movement are the corresponding coordinates in the scanning area of the position coordinates of the first three-dimensional mark during the exposure of the first wafer area combined with theoretical horizontal and vertical distances to be moved by the wafer area to be aligned with the projected exposure area in order to realize the alignment of the next wafer area. The horizontal and vertical theoretical movement distances of the wafer are predetermined and stored in the computer system according to the size of the wafer area generated by exposure and the distance between two adjacent wafer areas. The reference coordinates of a three-dimensional mark that was accurately positioned during the exposure of the wafer area in the previous step can be accurately determined according to the number of moved wafer areas. When performing alignment using the same 3D mark, the number of probe sensors and the range of the scanning area need to be considered. Since the same 3D mark needs to be tracked and scanned, two probe sensors can be optionally set to measure the coordinates of the 3D mark before the exposure of the wafer area and the same 3D mark after the wafer moves, respectively. Optionally it could use a probe sensor with a larger scanning range to realize tracking scanning of the same 3D mark.

Another alignment method is: After the exposure of the first wafer area is completed, the second wafer area is placed under the projection objective lens group, the probe sensor scans the position coordinates of the second three-dimensional mark and compares it with the reference coordinates of the second three-dimensional mark to obtain the deviation of the two position coordinates, the displacement actuating device adjusts the relative position of the exposure beam generating device and the wafer stage according to the difference in the position coordinates, so that the projected exposure area is aligned with the second wafer area, then realize the exposure of the second wafer area. The reference coordinates of the second three-dimensional mark are pre-stored in the computer control system. To ensure the accuracy of the alignment, optionally, the first three-dimensional mark is arranged close to the first wafer area, and the second three-dimensional mark is arranged close to the second wafer area.

The third alignment method is: After the exposure of the first wafer area is completed, the second wafer area is placed under the projection objective lens group, the probe sensor scans the graphics and coordinates of the three-dimensional pattern formed on the photosensitive layer after the first wafer area is exposed, and compares it with the reference graphics and coordinates of the three-dimensional pattern pre-stored in the computer control system to obtain two three-dimensional patterns difference in position, the displacement actuating device adjusts the relative position of the exposure beam generating device and the wafer stage according to the difference in the position coordinates, so that the projected exposure area is aligned with the second wafer area, then realize the exposure of the second wafer area.

One of the above three alignment methods can be selected according to whether the three-dimensional marks generated by the underlying alignment marks are set near the wafer area, or two or more alignment methods can be selected to improve alignment accuracy. When aligning a certain wafer area, more than one three-dimensional mark coordinates can be scanned at the same time and compared with the corresponding reference coordinates to improve the alignment accuracy.

The third wafer area and subsequent wafer areas are sequentially exposed under the projection objective lens group, and the exposure is realized according to the alignment method described above.

Optionally, the nano probe sensing device is fixed on one or both sides of the projection objective lens group and is relatively fixed in position between the groups of projection objective lens. When performing alignment using the same 3D mark, the number of probe sensors and the range of the scanning area need to be considered. Since the same 3D mark needs to be tracked and scanned, two probe sensors can be optionally set to measure the coordinates of the 3D mark before the exposure of the wafer area and the same 3D mark after the wafer moves, respectively. Another optional way is to select a probe sensor with a larger scanning range to realize tracking and scanning of the same three-dimensional mark. When two or more probe sensors are provided, the distance between two adjacent probe sensors is equal to the sum of the horizontal width of a wafer area and the width of the off-site area between two wafer areas. Optionally, the distance between two adjacent probe sensors is a multiple of the sum of the above two distances. Such a design can ensure that when the wafer area is sequentially exposed, the probe sensor can scan within a small range to achieve precise positioning of the three-dimensional mark. The positions of the plurality of probe sensors are fixed relative to each other through the connecting piece, to realize the transmission of a certain three-dimensional mark coordinate position on the wafer to the positions of other wafer areas on the transverse probe sensor array. In this way, the precise positioning of the wafer coordinates measured by any one probe sensor can be transmitted to the coordinate positioning measured by other probe sensors, and there is no error in the transmission.

The spacing between the probe sensors can be greater than or equal to the size of the wafer area plus the distance between wafer areas, so that one probe sensor measures the coordinate position of the 3D mark at or near the edge of the wafer, another probe sensor measures the 3D marks in the mid-space between wafer areas, and yet another probe sensor measures the mid-wafer area between wafer areas in another wafer area, and so on.

Specifically, the first probe sensor measures the position of 3D marks on the edge of the wafer, the horizontal probe sensor array transmits the absolute value of the position to the second probe sensor, which plays a role in determining the absolute coordinates of the position of the second probe sensor without setting a three-dimensional mark on the wafer. The coordinates of the first probe sensor can also be transmitted to the inner side of the wafer through the Nth probe sensor and have been transmitted to the last probe sensor head. The last probe sensor typically delivers measurements to 3D marks on the other edge of the wafer. The wafer area that the probe sensor cannot move to can transmit the exposure coordinate positioning of several wafer areas through the method of horizontal writing field splicing, due to the limited number of transfers, excessive positioning coordinate error accumulation is avoided, thereby forming a scene where all wafer areas on the wafer can be overlaid and precisely aligned for exposure.

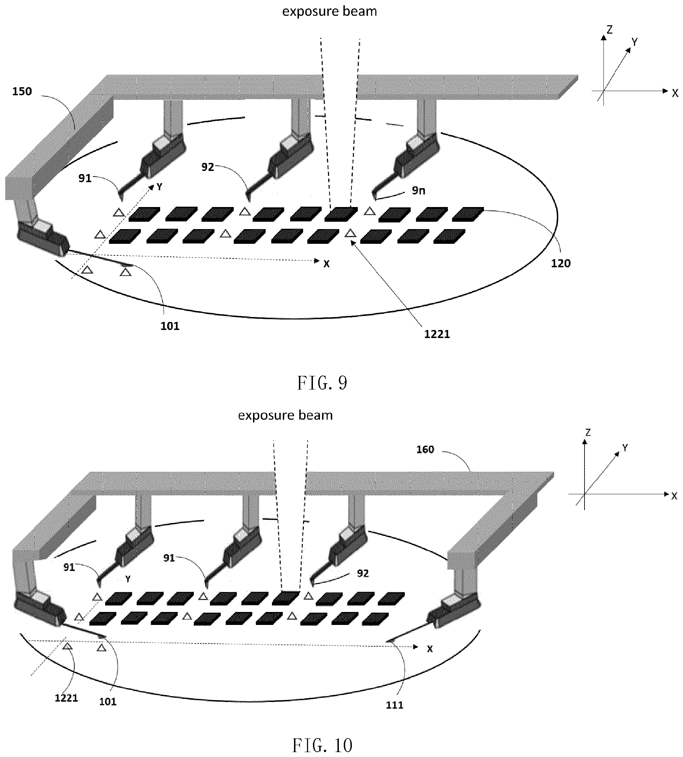

Using the probe sensor array to realize the nano-scale three-dimensional mark on the edge of the wafer, or the positioning of the nano-scale three-dimensional mark coordinates in the middle of the wafer relative to the beam, at least three three-dimensional mark should be used to ensure the positioning of the wafer relative to the beam. The wider the distribution of the three 3D marks on the wafer, the more accurately the wafer can be positioned. FIG. 9 is an array of L-shaped probe sensor heads with multiple probe sensors. The array can be positioned using 3D marks at very large distances from the wafer edge as exact coordinates of the wafer.

Fig. 9 shows a schematic diagram of the corresponding relationship between a plurality of probe sensors and wafer areas according to an embodiment of the present invention. In this embodiment, a plurality of probe sensors is connected in an L-shaped array through the connector 150. On the basis of the disclosed horizontal probe sensor array in the embodiment shown in FIG. 8, at least one probe sensor 101 capable of measuring other rows of three-dimensional marks in the edge area is added, this L-shaped array can be positioned using 3D marks at very large distances from the wafer edge as exact coordinates of the wafer.

It is one of the most accurate positioning methods to realize the positioning of the nano scale three-dimensional marks at both ends of the wafer edge and the relative position of the beam by the probe sensor array. Fig. 10 shows a schematic diagram of the corresponding relationship between a plurality of probe sensors and wafer areas according to an embodiment of the present invention. In this embodiment, a plurality of probe sensors is connected in a U-shaped array through the connector 160. Based on the disclosed horizontal probe sensor array in the embodiment shown in FIG. 8, at least one probe sensor 111 capable of measuring other rows of three-dimensional marks in the edge area is added at both ends. Therefore, the exact coordinate position of the wafer relative to the exposure light beam can be determined by setting more than three nano-scale three-dimensional marks spaced apart from each other at the two ends of the wafer. The array can be positioned using 3D marks at both ends of the wafer that are very far apart as the exact coordinates of the wafer. The arms of the U shape can be of different lengths. Its linear array of probe sensors can be fixed on the beam projection objective lens group and can also be fixed on the wafer stage.

The probe sensor measures the surface structure of the wafer under the atmosphere or vacuum environment or measures the surface structure of the wafer by immersing the probe sensor in the liquid under the environment of immersion. For liquid immersion lithography, said three-dimensional mark is a three-dimensional mark in an immersion liquid environment, or a three-dimensional mark corresponding to a region of wafer areas outside the same exposure beam without the corresponding three-dimensional marks of adjacent wafer areas in the immersion environment.

The surface structure data of the three-dimensional mark measured by the probe sensor is the mathematical convolution of the surface structure of the three-dimensional mark and the tip structure of the probe sensor. The shape of the probe sensor may affect the surface structure data of the three-dimensional marks detected by it, therefore the probe structure must be measured and calibrated before measuring the three-dimensional mark using the probe sensor, to improve the accuracy of measurement.

The situation described above mainly involves adjusting the position of the wafer in the horizontal, vertical or circumferential directions to achieve alignment with the projected exposure area. In some cases, the wafer may deviate from the perpendicularity of the exposure beam, such as a wafer that is supposed to be horizontally tilted at a certain angle. To detect this situation, three or more probe sensors can be set on different straight lines. When three or more probe sensors measure the 3D marks in their respective scanning areas respectively, it can be judged whether the wafer area where the 3D marks are located is tilted according to the height difference of the recognized 3D marks, resulting in a change in the distance between it and the probe sensor. And according to the measured height difference, the computer control system drives the wafer stage to adjust the wafer to be perpendicular to the exposure beam.

The sub-nano scale high-precision lithography wafer area overlay alignment method realized by the alignment device of the present invention includes the following preparatory steps:
Preparation Step 1: Beam Positioning Preparation. The probe sensor is fixed at the side position of the projection objective lens group of the exposure beam generating device, so the relative position of the probe sensor and the exposure beam is fixed. In this way, the coordinate system of the probe sensor is the coordinate system in which the exposure area projected by the exposure beam undergoes fixed translation. First, the wafer coated with the photosensitive layer (which can be a wafer with test structures) is aligned. Use a mask with a fine enough structure as a calibration mask. When the light beam is exposed through the mask, the pattern of the mask is transferred to the photosensitive layer on the wafer surface and forms a pattern area of the wafer area on the photosensitive layer. Due to the irradiation induced resist change (IIRC), a three-dimensional pattern on the surface of the photosensitive layer is generated. This three-dimensional pattern is the projected coordinate position of the beam on the wafer surface. Measuring the three-dimensional marks outside the wafer area and the IIRC three-dimensional pattern three-dimensional marks in the wafer area with the probe sensor determines the relative fixed coordinate position of the position of the beam projection exposure area and the coordinates of the probe sensor.

The probe sensor moves together with the coordinates of the projection objective lens group (that is, the beam projection pattern). Acts as the eyes of the exposure beam to find the exact position of the wafer area when using the probe sensor to measure the orientation of the wafer area.

Preparation Step 2: Wafer Preparation, before or after the wafer is coated with the photosensitive layer, the probe sensor is used to measure the coordinate position of the three-dimensional mark in each wafer area to determine the mutual position of the three-dimensional mark coordinates outside the field.

Preparation Step 3: Find out the projected exposure area coordinates of each wafer area exposure on the first wafer.

Method one: Before the wafer is exposed by lithography, there is no pattern on the wafer, so there is no alignment problem of the projection exposure area and the pattern left on the wafer after the previous exposure. The pattern area of the first wafer area can be formed simply according to the beam projection exposure, and then the wafer stage moves to the next wafer area to expose the pattern until all the patterns on the wafer are exposed. Measure the coordinates of the off-site three-dimensional mark of each wafer area by the probe sensor and measure the three-dimensional mark coordinates of the three-dimensional pattern in the field obtained by measuring the change of the photosensitive layer in the projected exposure area of the wafer area (IIRC). The coordinates of the off-site three-dimensional mark in the wafer area can be linked with the position coordinates of the projected exposure area of the wafer area, in the further, the position of the projected exposure area can be determined only by measuring the coordinates of the three-dimensional mark outside the wafer area.

Method two: After the wafer is exposed for the first time and the exposure pattern on the photosensitive layer is transferred to the wafer, such as by plasma etching, directly measure and record the coordinates of the 3D mark outside the wafer area and the coordinate position of the 3D mark of the three-dimensional pattern in the wafer area, so that in the future, as long as the three-dimensional mark coordinates outside the wafer area are measured, the position of the projected exposure area of the wafer area can be calculated. Measurements can be made by probe sensors, or by other measuring instruments other than lithography apparatus.

Preparation Step 1, 2 und 3 need to be done only once, after initially measuring the wafer once, off-site 3D marks can be used to determine the coordinate location of the wafer area.

Wafer area coordinate reference point. Through the above preparatory steps, the wafer area coordinates are associated with the coordinates of the off-site three-dimensional marks for each wafer area. The position coordinates of the wafer area can be determined by checking the coordinates of the off-site 3D marks.

Preparation Step 4: If the measured array of each wafer area on the wafer has an angular deviation from the wafer stage carrying the wafer, it is necessary to calibrate the angular error between the wafer and the horizontal two-dimensional movement direction of the wafer stage, that is, the circumferential direction. After completing the above preparatory steps, proceed to the wafer area overlay alignment step:
Alignment Step 1: The first wafer area overlay alignment process begins. The wafer 110 coated with the photosensitive layer 120 is placed on the wafer stage 100, measure the three-dimensional mark outside the wafer area through the probe sensor fixed on the beam projection objective lens group 70, using the coordinates of the off-site 3D mark obtained in preparation step 3 in relation to the fixed coordinates of the graphic area of the wafer area, it is possible to determine whether the beam is oriented to the position of the graphic area of the wafer area. Thus, the coordinate deviation between the beam projection exposure area and the pattern area of the wafer area can be obtained, i.e. (ΔX₁, ΔY₁).
Alignment Step 2: Using the nanometer displacement actuating device 61 fixed to the mask plate, the coordinates (ΔX₁, ΔY₁) obtained in the alignment step 1 are moved to the mask plate for compensation corresponding to the error amount, so that the projection exposure area is aligned with the pattern area of the wafer area.
Alignment Step 3: Exposing the first wafer area within the projected exposure area.
Alignment Step 4: Enabling the probe sensor to measure the coordinates of the three-dimensional mark outside the field and the position of the three-dimensional mark of the IIRC three-dimensional pattern inside the exposed wafer area; This is equivalent to re-measurement of the coordinate position of the wafer area and the position of the beam projection exposure area, and real-time calibration of the position of the wafer area and the position of the beam projection exposure area. In this way, even if some parts in the lithography apparatus have slight drift over time, it can be corrected in this step.
Alignment Step 5: Pre-exposure preparation of the second wafer area is performed. Moving the wafer stage 100 drives the wafer 110 to move horizontally, the area of the first wafer that has just been exposed is moved out of the projection exposure area to become a wafer area with a three-dimensional pattern, making room for the subsequent entry of the second wafer area of the wafer into the projection exposure area. The movement of the wafer stage will cause positioning errors in the wafer area;
Alignment Step 6: Start the probe sensor to measure and identify the coordinates of the off-site three-dimensional mark corresponding to the second wafer area, comparing the off-site three-dimensional mark coordinates and/or the three-dimensional pattern three-dimensional mark coordinates of the IIRC on site related to the above-mentioned first wafer area moved out of the projection exposure area, the deviation (ΔX₂, ΔY₂) that the second wafer area needs to move is obtained;
Alignment Step 7: Using the nanometer displacement actuating device 61 fixed to the mask plate, the mask plate is driven to make phase compensation movement corresponding to the error amount according to the coordinates (ΔX₂, ΔY₂) obtained in the alignment step 6, so that the beam projection exposure area is aligned with the pattern area under the photosensitive layer of the wafer area.
Alignment Step 8:Exposing a second wafer area within the projected exposure zone.
Alignment Step 9:Using the probe sensor to measure the coordinates of off-site 3D marks or/and the position of on-site IIRC three-dimensional pattern 3D marks in the exposed wafer area.
Alignment Step 10:The pre-exposure preparation of the third wafer area is performed. Moving the wafer stage 100 drives the wafer 110 to move horizontally, the area of the second wafer that has just been exposed is moved out of the projection exposure area to become a wafer area with a three-dimensional pattern, making room for the subsequent entry of the third wafer area of the wafer into the projection exposure area. The movement of the wafer stage will cause positioning errors in the wafer area.
Alignment Step 11: Start the probe sensor to measure and identify the coordinates of the off-site three-dimensional marks associated with the third wafer area and measure the above-mentioned three-dimensional pattern three-dimensional marks in the second wafer area IIRC that are moved out of the projected exposure area, comparing with the coordinates of the off-site 3D mark and/or the coordinates of the three-dimensional pattern IIRC on-site IIRC with respect to the first wafer area moved out of the projected exposure area, the deviation (ΔX₃, ΔY₃) that the second wafer area needs to move is obtained;
Alignment Step 12: Using the nanometer displacement actuating device 61 fixed to the mask plate, the mask plate is driven to make phase compensation movement corresponding to the error amount according to the coordinates (ΔX₃, ΔY₃) obtained in the alignment step 11, so that the beam projection exposure area is aligned with the pattern area under the photosensitive layer of the wafer area.
Alignment Step 13: Repeatedly, the entire wafer area of the wafer is exposed, moved and scribed.

The three-dimensional mark used for alignment described in this embodiment can not only be selected from the off-site three-dimensional mark in the middle zone between the wafer area that is about to be exposed and the adjacent wafer area, but also can be selected from the surface of the previous exposure wafer area (has been coated with The IIRC three-dimensional pattern of the photosensitive layer) serves as a coordinate reference system for the exposure of the next wafer area. Since there is no need to set three-dimensional marks between wafer regions using IIRC, the setting of three-dimensional marks between wafer regions can be greatly reduced. However, using the IIRC three-dimensional pattern as the coordinate system of the last exposed wafer area will lead to the accumulation of errors caused by the probe sensor measuring each exposed wafer area. Therefore, in general, the wafer area with the corresponding three-dimensional mark and the wafer area without the corresponding off-site three-dimensional mark are set at intervals, by using several IIRC patterns as reference points for the alignment and positioning of projected exposure areas, off-site 3D marks between several wafer areas are omitted, while ensuring that the accumulated total error is within an allowable range.

In the embodiment shown in Fig. 8-Fig. 10 of the present invention, the combination of the linear array with a plurality of probe sensors and the off-site three-dimensional mark in the wafer area and the IIRC three-dimensional mark in the wafer area can reduce the number of off-site three-dimensional marks in a smaller amount. Specifically, the horizontal probe sensor array directly binds the movement error of the first probe sensor and other probe sensors fixed on the linear array of probe sensors to the position of the first probe sensor, avoids the accumulation of errors that may be introduced by multiple wafer areas in the middle due to not using 3D marks in the middle zone between neighboring wafer areas to confirm wafer area positioning.

In another embodiment it is possible to set nanoscale three-dimensional marks only at the edge of the wafer, and then use a linear array of multiple probe sensors to connect the coordinate positions inside the wafer directly to the coordinate positions of the three-dimensional marks in the wafer area identified by the edge of the wafer through the linear array of probe sensors, eliminating the accumulation of errors brought about by multiple wafer areas exposed back and forth in the middle, with reference to the previous wafer area exposure.

Through the above description, in order to improve the overlay accuracy of the wafer during step-by-step exposure, the present invention is mainly achieved through the following technical solutions:
Technology for measuring the actual coordinate position of the wafer area/writing field with sub-nanometer precision.

Using tip sensing technology, including probe sensor atomic force microscopy technology. Atomic Force Microscopy is one of the probe sensor technologies, can measure the three-dimensional surface topography of the wafer with sub-nanometer precision, as well as the nano-scale distribution of the surface work function, etc.

Sub-nanometer displacement actuation technology for objects_{∘}

The first technology is piezoelectric ceramic technology that moves in sub-nanometer steps, which can produce sub-nanometer movement using the principle of piezoelectricity. However, the general piezoelectric movement is nonlinear and has a hysteresis loop.

The second technology is electromagnetic drive technology. Voice coil motor is a special form of direct drive motor. It has the characteristics of simple structure, small size, high speed, high acceleration, and fast response. Its positioning accuracy can reach the order of 1/30 nanometers. Its working principle is that when an energized coil (conductor) is placed in a magnetic field, a force is generated, and the magnitude of the force is proportional to the current applied to the coil. The motion form of the voice coil motor manufactured based on this principle can be straight line or circular arc. Both techniques can be used in the present invention.

With the above measurement and actuation techniques, sub-nanometer positioning can be achieved. This positioning is to adjust the wafer area/writing field of the wafer relative to the photon beam/electron beam for nanoscale positioning displacement adjustment, to eliminate the relative coordinate offset caused by the movement of the wafer stage or the movement of the photon beam/electron beam. In this way, a variety of methods and devices for correcting the position error of the wafer region/writing field that deviate from the position of the photon beam/electron beam can be provided, to realize the horizontal stitching and vertical alignment of the wafer region/writing field at the sub-nanometer level. Example implementation of displacement driving and positioning of objects:
In photon beam/electron beam lithography apparatus, sub-nanometer-level positioning of the wafer stage can be used, or to set up a more accurate picometer-level small wafer stage on the existing wafer stage for precise positioning, that is, the moving step size is smaller than that of the conventional wafer stage. (Small wafer stages can move slower).

In the photon beam/electron beam lithography apparatus using the mask plate, a actuating device that drives the nanoscale movement of the mask plate working stage can be set, the nanoscale movement of the driving photon beam/electron beam projection objective lens group can be set, which is enough to realize the correction of the alignment error of the wafer area/write field.

In the photon beam/electron beam direct writing lithography apparatus, it can be set to drive the displacement of the group of photon beam/electron beam projection objective lens , so that the lens can move several or tens of nanometers, which is enough to correct the alignment error relative to the writing field/wafer area.

In the photon beam/electron beam direct writing or mask plate lithography apparatus, it can be set to drive the photon beam/electron beam itself or the deflection device to realize the displacement and coordinate correction of the photon beam and electron beam.

Provided is a device and method for closed-loop control measurement and alignment of wafer areas in a lithography apparatus followed by exposure.

The lithography apparatus alignment system disclosed in the present invention has the characteristics of measurement-movement-remeasurement closed-loop control of overlay alignment in the wafer area, and the specific overlay alignment method for the wafer area of the ultra-high-precision lithography system is as follows:
Method one: Using the off-site three-dimensional mark 1221 as a reference point for alignment and positioning of the wafer area, such as the coordinate position of 3D protruding (concave) marks between wafer areas or on the edge of the wafer, that is, the position of the wafer area pattern is measured by the probe sensor (The coordinate position and relative coordinate position of each wafer area pattern on the wafer and the three-dimensional protruding (concave) mark on the wafer are determined in advance, and are not affected by the movement of the wafer stage and the offset of the beam). Then move the exposed wafer area out of the projection exposure area by moving the wafer stage 100, and continue to measure the new coordinates of the three-dimensional protruding (concave) marks in the middle of the wafer area or on the edge of the wafer, and compare the formed coordinate difference with the coordinates of the previously exposed wafer area in the projection exposure area to obtain the coordinate offset difference of the next wafer area to be exposed. This coordinate difference can be used to drive the exposure beam generating device such as the mask plate to perform nanoscale horizontal movement for compensation, and can also be set to drive the nanoscale horizontal movement of the group of photon beam/electron beam projection objective lens, can also be set to drive the nanoscale horizontal movement of the photon beam/electron beam itself or the deflection reflector, and can also be set to drive the wafer stage or a piezoelectric wafer stage with a smaller step size installed on the wafer stage, to achieve correction of alignment errors in the wafer area/writing field.
Method two: The three-dimensional pattern formed by the irradiation induced resist change (IIRC) after the exposure of the first wafer area, as shown in Figure 5A and 5B, is used as the position coordinates for the alignment of the next wafer area. In this method, the area of the wafer to be exposed may not be provided with a corresponding three-dimensional mark, that is, no three-dimensional mark is provided in or around the wafer area. When the probe sensor scans in a certain scanning area, the boundary of the wafer area is determined according to the three-dimensional pattern of the three-dimensional mark formed on the wafer area that has been exposed before, then it can be determined whether the area of the next wafer to be exposed needs to be fine-tuned at the nanometer level and the deviation of the adjustment.
Method three: This method is set in combination with the above method 1 and method 2. Considering that the best implementation mode of the method 1 is to set three-dimensional marks corresponding to each wafer area, since there are many wafer areas on a wafer, quite a lot of bottom alignment marks need to be fabricated on the wafer in advance, however, in the second method, the three-dimensional mark of the exposed three-dimensional pattern in the area of the previous wafer may be used for positioning, and there may be a problem of accumulating errors, therefore, in this method, method 1 and method 2 are combined, it is to set the interval between the wafer area where the corresponding 3D mark is set and the wafer area where the 3D mark is not set. That is, the three-dimensional mark corresponding to the wafer area is used as an absolute reference point to realize the exposure overlay alignment of the first wafer area, the irradiation induced resist change (IIRC) of the wafer area exposure is then used as the alignment coordinates of the horizontal wafer area, and the alignment is transferred to the alignment and exposure of the next wafer area. After transferring the exposure of several wafer areas, the three-dimensional mark corresponding to the wafer region is obtained again as the absolute overlay alignment mark, and the absolute exposure alignment of the next wafer areas is restarted. This greatly reduces the amount of bottom alignment marks placed on the wafer while maintaining overlay accuracy in all wafer areas.

The invention is applicable to deep ultraviolet and extreme ultraviolet optical lithography apparatus, solves the technical problem that the photon beam cannot be used to directly face the wafer coated with the photosensitive layer for alignment measurement before exposure, and the wafer area can only be positioned by moving the wafer stage. The technical solution disclosed by the invention will not produce cumulative errors. Therefore, it is avoided that the wafer stage must return to the origin every time and move to the designated position with the origin as the absolute reference point, which will greatly improve the working speed. In addition, the present invention also solves the problem that even if the positioning of the wafer stage is accurate, due to the drift of the projection objective lens group of the photon beam and the mask plate (through various factors such as thermal expansion and contraction), the photon beam will drift, which will complicate the alignment of the final photon beam with the wafer.

The above methods are all based on the closed-loop control principle of the relative position between the wafer and the exposure beam to perform overlay alignment of the wafer area. This alignment mechanism is more accurate than a precise wafer stage, because even if the wafer stage is temporarily positioned precisely, the beam drift on the wafer is difficult to compensate by the wafer bench, as well as the laser interferometer that aligns between the wafer and the beam.

Although the content of the present invention has been described in detail through the above preferred embodiments, the above description should not be considered as limiting the present invention. Various modifications and alterations to the present invention will become apparent to those skilled in the art upon reading the above disclosure. Therefore, the protection scope of the present invention should be defined by the appended claims.

## Claims

1. A lithography pattern alignment device being provided in a photolithography apparatus, **characterized in that** said device includes:
a wafer stage being used to carry wafer to be processed, wherein the wafer include several wafer areas and an off-site area around the wafer areas, a photosensitive layer is provided on a surface of the wafer, and the photosensitive layer is provided with three-dimensional marks, and the three-dimensional marks have a region that is not on the same level as an upper surface of the photosensitive layer;
a nano probe sensing device including a probe sensor, wherein the probe sensor is located over the photosensitive layer, and is used to move and scan in a scanning area and determine the coordinates of the three-dimensional marks in the scanning area;
an exposure beam generating device being used to provide an exposure beam required for exposure of the wafer area, and form a projected exposure area on the photosensitive layer;
a displacement actuating device being configured to adjust a relative position of the exposure beam generating device and the wafer stage according to the coordinates of the three-dimensional marks measured by the probe sensing device, so that the projected exposure area is aligned with an area of the wafer to be exposed.

2. The lithography pattern alignment device according to claim 1, **characterized in that**: the device further includes a computer control system, wherein the computer control system is used to receive the coordinates of the three-dimensional mark measured by the nano probe sensing device and compare them with reference coordinates of the three-dimensional mark to obtain the difference between the two coordinates; the computer control system is used to transmit the difference to the displacement actuating device, and control the exposure beam generating device and/or the wafer stage to move relative to each other to compensate for the difference.

3. The lithography pattern alignment device according to claim 2, **characterized in that**: the reference coordinates are coordinates of a preset position of the three-dimensional mark when the three-dimensional mark is at the preset position, the area of the wafer to be exposed is aligned with the projected exposure area, and the reference coordinates are pre-stored in the computer control system.

4. The lithography pattern alignment device according to claim 2, **characterized in that**:the reference coordinates are a corresponding coordinates in said scanning area, wherein the corresponding coordinates are formed by combining coordinates measured by said nano probe sensing device for said three-dimensional mark before the exposure of the wafer area with a theoretical distance that the wafer is to be moved to align a next wafer area to be exposed with the projection exposure area, theoretical distance that the wafer is to be moved in the horizontal and vertical directions is pre-stored in the computer control system.

5. The lithography pattern alignment device according to claim 1, **characterized in that**: the three-dimensional marks on the photosensitive layer include three-dimensional marks formed on the photosensitive layer and corresponding to underlying alignment marks provided below the photosensitive layer and/or three-dimensional patterns formed by irradiation induced resist change (IIRC) formed after exposure of the surface of the photosensitive layer by the exposure beam.

6. The lithography pattern alignment device according to claim 5, **characterized in that**:the three-dimensional mark formed on the photosensitive layer and corresponding to said underlying alignment mark is located within said wafer area or within the off-site area between adjacent wafer areas.

7. The lithography pattern alignment device according to any one of claims 5 or 6, **characterized in that**: the underlying alignment marks include marks made on a surface of a wafer substrate before the first exposure of the wafer and/or marks provided under the photosensitive layer in a subsequent exposure process.

8. The lithography pattern alignment device according to claim 1, **characterized in that**:
a height of the three-dimensional mark is greater than surface roughness of the photosensitive layer.

9. The lithography pattern alignment device according to claim 1, **characterized in that**:the coordinates of the three-dimensional mark include horizontal coordinates, vertical coordinates and circumferential coordinates of the wafer.

10. The lithography pattern alignment device according to claim 1, **characterized in that**:two or more three-dimensional marks are set on the photosensitive layer.

11. The lithography pattern alignment device according to claim 1, **characterized in that**: the three-dimensional mark has certain graphic features, and the graphic features include at least one dot-form feature, and the dot-form feature is in a different horizontal plane from that of the upper surface of the photosensitive layer.

12. The lithography pattern alignment device according to claim 1, **characterized in that**: the graphic features further include ridge features connected to the dot-form features, and the ridge features are not completely located in a same plane as the upper surface of the photosensitive layer.

13. The lithography pattern alignment device according to claim 1, **characterized in that**: the three-dimensional mark is a three-dimensional structure protruding or recessing on an upper surface of the photosensitive layer.

14. The lithography pattern alignment device according to claim 13, **characterized in that**: the three-dimensional structure is at least one of a pyramidal structure, a polygonal prism structure, and a pyramidal structure.

15. The lithography pattern alignment device according to claim 1, **characterized in that**:each wafer area is provided with at least one three-dimensional mark, said three-dimensional mark is located in said wafer area or in an off-site area around said wafer area, reference coordinates of said three-dimensional mark are stored in advance in the computer control system.

16. The lithography pattern alignment device according to claim 1, **characterized in that**: part of the wafer area is not provided with a corresponding three-dimensional mark and is aligned with the projected exposure area according to three-dimensional mark of the three-dimensional patterns in the previous exposed wafer area measured by the probe sensor.

17. The lithography pattern alignment device according to claim 16, **characterized in that**:the wafer area without the corresponding three-dimensional mark is spaced apart from the wafer area with the corresponding three-dimensional mark.

18. The lithography pattern alignment device according to claim 1, **characterized in that**:the exposure beam generating device is provided with a positioning mark generating device, and the positioning mark generating device forms a three-dimensional positioning mark on a periphery of the wafer area while exposing the wafer area, the probe sensor calibrates a position of the wafer area to be exposed according to the three-dimensional positioning mark.

19. The lithography pattern alignment device according to claim 1, **characterized in that**:a height of said three-dimensional mark is less than or equal to 50 microns.

20. The lithography pattern alignment device according to claim 1, **characterized in that**:theprobe sensor is one or combinations of atomic force probe sensor with active cantilever, atomic force probe sensor with laser reflective cantilever, probe sensor head for tunnelingelectron or sensor head for nanoscale surface work function measurement.

21. The lithography pattern alignment device according to claim 1, **characterized in that**:the probe sensor measures a structure of a surface of the wafer under the atmosphere or vacuum environment, or measures a structure of a surface of the wafer by immersing the probe sensor in the liquid under an environment of immersion.

22. The lithography pattern alignment device according to claim 21, **characterized in that**:for liquid immersion lithography, said three-dimensional mark is a three-dimensional mark in an immersion liquid environment, or a three-dimensional mark corresponding to a region of wafer areas adjacent to a wafer areas outside the same exposure beam and without immersion environment.

23. The lithography pattern alignment device according to claim 1, **characterized in that**:data of a structure of a surface of the three-dimensional mark measured by the probe sensor is the mathematical convolution of the structure of the surface of the three-dimensional mark and a structure of the tip of the probe sensor, a structure of the probe is measured and calibrated before measuring the three-dimensional mark using the probe sensor.

24. The lithography pattern alignment device according to claim 1, **characterized in that**:the nano tip sensing device further comprises a micro-cantilever, said micro-cantilever is fixed at one end and said probe sensor is provided at the other end.

25. The lithography pattern alignment device according to claim 24, **characterized in that**:the nano tip sensing device includes one or more probe sensors, and the probe sensors are fixed on one side or both sides of the exposure beam generating device through the micro cantilever.

26. The lithography pattern alignment device according to claim 25, **characterized in that**: the exposure beam generating device includes a projection objective lens group arranged above the wafer, and the one or more probe sensors are fixed on one side or both sides of the projection objective lens group through the microcantilever.

27. The lithography pattern alignment device according to claim 24, **characterized in that**: the wafer stage includes a moving part and a fixed part, and the probe sensor is connected to the fixed part through the micro-cantilever.

28. The lithography pattern alignment device according to claim 27, **characterized in that**: the nano tip sensing device includes two or more probe sensors, wherein one or more probe sensors are fixed on a fixed part of the wafer stage, one or more of the probe sensors are fixed on a side of the exposure beam generating device, and the relative distance between probe sensors is fixed.

29. The lithography pattern alignment device according to claim 1, **characterized in that**:the nano tip sensing device includes two or more probe sensors, several of the probe sensors are fixed on one side or both sides of the exposure beam generating device through a connecting member, and the relative distance between the probe sensors is fixed.

30. The lithography pattern alignment device according to claim 1, **characterized in that**:the nanotip sensing device includes three or more probe sensors, and the probe sensors are fixed on a fixed part of the wafer stage through connecting members and/or are fixed on the exposure beam generating device through connecting members, the probe sensors are located on different straight lines to determine whether the wafer is perpendicular to the exposure beam.

31. The lithography pattern alignment device according to claim 30, **characterized in that**:each of the probe sensors tests the distance from the surface of ther wafer or the surface of the photosensitive layer corresponding to a position of the probe sensor to the exposure beam generating device, whether the wafer is perpendicular to the exposure beam is determined based on the measured distance is the same or not, and the wafer is adjusted to be perpendicular to the exposure beam through the computer control system driving said wafer stage.

32. The lithography pattern alignment device according to any one of claims 26-29, **characterized in that**: the nano tip sensing device includes a plurality of probe sensors fixed by connecting members, and the plurality of probe sensors are horizontally arranged in a row according to the distribution of the wafer area to form a horizontal array of probe sensors.

33. The lithography pattern alignment device according to claim 32, **characterized in that**:at least one probe sensor distributed vertically is arranged at one end of the horizontal array of the probe sensors to form a L-shaped array of the probe sensors.

34. The lithography pattern alignment device according to claim 32, **characterized in that**: both ends of the horizontal array of the probe sensors are respectively provided with probe sensors vertically distributed to form a U-shaped array of the probe sensors.

35. The lithography pattern alignment device according to claim 32, **characterized in that**: the distance between the two adjacent probe sensors is greater than or equal to the horizontal width of one wafer area.

36. The lithography pattern alignment device according to claim 1, **characterized in that**:the displacement actuating device includes a wafer area switching actuating device and a nanometer displacement actuating device.

37. The lithography pattern alignment device according to claim 36, **characterized in that**: the wafer area switching actuating device is connected with the moving part of the wafer stage, and is used to drive an area of the wafer to be exposed to be sequentially exposed under the projection exposure area.

38. The lithography pattern alignment device according to claim 36, **characterized in that**: the moving part of the wafer stage further includes a precision movement device, and the nanometer displacement actuating device is the precision movement device.

39. The lithography pattern alignment device according to claim 36, **characterized in that**: the nanometer displacement actuating device is connected to the exposure beam generating device and/or the precision movement device of the wafer stage, and is used to control the movement of the exposure beam generating device and/or the wafer stage in the horizontal and/or vertical and/or circumferential direction.

40. The lithography pattern alignment device according to claim 36, **characterized in that**: working principle of the nanometer displacement actuating device for driving the exposure beam generating device and/or the precision movement device is at least one of piezoelectric principle, voice coil driving principle or electromagnetic driving principle.

41. The lithography pattern alignment device according to claim 1, **characterized in that**:the exposure beam emitted by the exposure beam generating device is at least one of light beam, electron beam, ion beam or atomic beam.

42. The lithography pattern alignment device according to claim 36, **characterized in that**: the exposure beam generating device is a beam generating device, and the beam generating device includes a light source, a shutter, a beam deflector/reflector, a mask plate and a projection objective lens group, the nanometer displacement actuating device is connected to at least one of the beam deflector /reflector, the mask plate and the projection objective lens group, to adjust the position of the projection exposure area of the beam generating device.

43. The lithography pattern alignment device according to claim 42, **characterized in that**: at least one said probe sensor is fixed on at least one side of the projection objective lens group.

44. The lithography pattern alignment device according to claim 41, **characterized in that**:the exposure beam is a parallel beam or a Gaussian beam.

45. The lithography pattern alignment device according to claim 42, **characterized in that**: the shaping and focusing system for the light beam is composed of optical lenses or optical reflectors.

46. The lithography pattern alignment device according to claim 1, **characterized in that**: the wafer includes a whole wafer, a partial wafer, or a non-wafer material that requires a photolithography exposure treatment.

47. A stepper lithography apparatus for repeated exposure of a plurality of wafer areas within a wafer, **characterized in that**: said lithography apparatus is provided with a lithography pattern alignment device as claimed in any one of claims 1-46.

48. An operating method of a stepper lithography apparatus, **characterized in that** the method comprises:
preparation step, setting at least one bottom alignment mark on the wafer and coating a photosensitive layer on said wafer to be processed, said bottom alignment mark forming a three-dimensional mark on said photosensitive layer correspondingly;
alignment step, placing the wafer provided with the three-dimensional mark in the preparation step in the lithography apparatus according to claim 47, a projection objective lens group are set close to the wafer in the lithography apparatus, and the projection objective lens group corresponds to a projection exposure area on the wafer, driving the wafer stage to place the first wafer area to be exposed under the projection objective lens group; scanning the photosensitive layer within a certain scanning area by using the probe sensor to obtain the coordinates of position of the first three-dimensional mark, comparing the coordinates of the position of the first three-dimensional mark with the reference coordinates of the first three-dimensional mark to obtain the difference between the two coordinates; the displacement actuating device adjusts the relative position of the exposure beam generating device and the wafer stage according to the difference between the two coordinates, so that the projected exposure area is aligned with the first wafer area;
exposure step, the beam generating device emits an exposure beam to the first wafer area of the wafer to realize the exposure of the first wafer area.

49. The method of claim 48, **characterized in that**: the second wafer area is placed under the projection objective lens group after the exposure of the first wafer area is completed, the probe sensor scans coordinates of a position of the first three-dimensional mark having been moved and compares them with the reference coordinates of the first three-dimensional mark having been moved to obtain the deviation of the two coordinates, the displacement actuating device adjusts a relative position of the exposure beam generating device and the wafer stage according to the difference of the coordinates, to align the projected exposure area with the second wafer area and then realizing exposure of the second wafer area.

50. The method of claim 49, **characterized in that**: the reference coordinates of the first three-dimensional mark having been moved are corresponding coordinates in the scanning area, wherein the corresponding coordinates are formed by combining coordinates of said first three-dimensional mark when the wafer area is exposed with a theoretical distance that the wafer is to be moved to align a next wafer area to be exposed with the projection exposure area.

51. The method according to any one of claims 49 or 50, **characterized in that**: at least one probe sensors are arranged on both sides of the projection objective lens group respectively, or a probe sensor is arranged on one side of the projection objective lens group, and a scan width of the probe sensor is greater than the width of a wafer area to be exposed.

52. The method of claim 48, **characterized in that**: the second wafer area is placed under the projection objective lens group after the exposure of the first wafer area is completed, the probe sensor scans coordinates of second three-dimensional mark and compares them with reference coordinates of the second three-dimensional mark to obtain the difference of the two coordinates, the displacement actuating device adjusts relative position of the exposure beam generating device and the wafer stage according to the difference of the coordinates, to align the projected exposure area with the second wafer area and then realizing exposure of the second wafer area, the reference coordinates of the second three-dimensional mark are pre-stored in the computer control system.

53. The method of claim 52, **characterized in that**: the first three-dimensional mark is disposed close to the first wafer area, and/or the second three-dimensional mark is disposed close to the second wafer area.

54. The method of claim 48, **characterized in that**: the second wafer area is placed under thethe projection objective lens group after the exposure of the first wafer area is completed, the probe sensor scans the graphics and coordinates of the three-dimensional pattern formed on the photosensitive layer after the area of the first wafer is exposed, and compares them with the preset graphics and coordinates of the three-dimensional pattern to obtain the difference between the positions of the two three-dimensional patterns, the displacement actuating device adjusts relative position of the exposure beam generating device and the wafer stage according to the difference of the coordinates, to align the projected exposure area with the second wafer area and then realizing exposure of the second wafer area.

55. The method according to any one of claims 48-54, **characterized in that**: the nano probe sensing device is fixed on one or both sides of the projection objective lens group, and relative position between the nano probe sensing device and the projection objective lens group group.
